# EUROPEAN PATENT APPLICATION

(11) **EP 2 378 362 A1**
(43) Date of publication of application: **19.10.2011**
(21) Application number: 09822037.9
(22) Date of filing: 21.10.2009
(51) Int. Cl.: G03F 7/40, H01L 21/027

(54) **RESIST PATTERN COATING AGENT AND RESIST PATTERN FORMING METHOD USING THE SAME**

(30) Priority: 21.10.2008 JP 2008271194
(71) Applicant: JSR Corporation, Tokyo 105-8640 (JP)
(72) Inventor: YADA, Yuji, Tokyo 105-8640 (JP); ANNO, Yusuke, Tokyo 105-8640 (JP); KAKIZAWA, Tomohiro, Tokyo 105-8640 (JP); HORI, Masafumi, Tokyo 105-8640 (JP); MITA, Michihiro, Tokyo 105-8640 (JP); WAKAMATSU, Goji, Tokyo 105-8640 (JP)
(74) Representative: TBK
(86) International application number: PCT/JP2009/068093
(87) International publication number: WO 2010/047340

(57) **Abstract**

A resist pattern coating agent includes a hydroxyl group-containing resin, and a solvent that includes a branched alkyl alcohol having 3 to 10 carbon atoms in an amount of 30 mass% or more, the resist pattern coating agent being used in a step (2) of a resist pattern-forming method that includes (1) forming a first resist pattern on a substrate using a first radiation-sensitive resin composition, (2) treating the first resist pattern with the resist pattern coating agent, and (3) forming a second resist pattern on the substrate treated with the resist pattern coating agent using a second radiation-sensitive resin composition.

## Description

### TECHNICAL FIELD

The present invention relates to a resist pattern coating agent and a resist pattern-forming method using the same. More specifically, the invention relates to a resist pattern coating agent that can suppress LWR (variation in line width) and a top loss (reduction in resist pattern) when forming a pattern, and a resist pattern-forming method that can conveniently and efficiently form a fine resist pattern.

### BACKGROUND ART

In the field of microfabrication (e.g., production of integrated circuit devices), lithographic technology that enables microfabrication with a line width of 0.10 µm or less has been desired in order to achieve a higher degree of integration. A lithographic process has utilized near ultraviolet rays (e.g., i-line). However, it is difficult to implement sub-quarter-micrometer microfabrication using near ultraviolet rays. Therefore, use of radiation having a shorter wavelength has been studied in order to implement microfabrication with a line width of 0.10 µm or less. Examples of radiation having a short wavelength include deep ultraviolet rays (e.g., mercury lamp bright line spectrum and excimer laser light), X-rays, electron beams, and the like. In particular, KrF excimer laser light (wavelength: 248 nm) and ArF excimer laser light (wavelength: 193 nm) have attracted attention.

As a resist suitable for excimer laser irradiation, a number of resists (chemically-amplified resists) that utilize a chemical amplification effect due to an acid-dissociable functional group-containing component and a component (acid generator) that generates an acid upon irradiation (exposure) have been proposed. For example, a chemically-amplified resist that includes a resin containing a t-butyl ester group of a carboxylic acid or a t-butyl carbonate group of phenol, and an acid generator, has been proposed (see Patent Document 1, for example). This resist utilizes a phenomenon in which the t-butyl ester group or the t-butyl carbonate group contained in the resin dissociates due to an acid generated upon exposure to form an acidic group (e.g., carboxyl group or phenolic hydroxyl group), so that the exposed area of the resist film becomes readily soluble in an alkaline developer.

A lithographic process will be required to form a finer pattern (e.g., a fine resist pattern having a line width of about 45 nm). Such a fine pattern may be formed by reducing the wavelength of the light source of the exposure system, or increasing the numerical aperture (NA) of the lens, for example. However, an expensive exposure system is required to reduce the wavelength of the light source. When increasing the numerical aperture (NA) of the lens, since the resolution and the depth of focus have a trade-off relationship, the depth of focus decreases as a result of increasing the resolution.

In recent years, liquid immersion lithography has been proposed as lithographic technology that can solve the above problems (see Patent Document 2, for example). In liquid immersion lithography, a high-refractive-index liquid medium (immersion liquid) (e.g., pure water or fluorine-containing inert liquid) is provided at least between the lens and the resist film formed on the substrate during exposure. According to liquid immersion lithography, the optical space (path) is filled with a liquid (e.g., pure water) having a high refractive index (n) instead of an inert gas (e.g., air or nitrogen) so that the resolution can be increased without causing a decrease in depth of focus in the same manner as in the case of using a short-wavelength light source or a high NA lens. Since a resist pattern that exhibits a high resolution and an excellent depth of focus can be inexpensively formed by liquid immersion lithography using a lens provided in an existing system, liquid immersion lithography has attracted attention, and is put to practical use.

However, it is considered that liquid immersion lithography can only be applied up to 45 nmhp. Therefore, technical development toward a 32 nmhp generation has been conducted. In recent years, technology that forms a 32 nm line-and-space (LS) pattern by forming isolated line patterns or trench patterns shifted by a half pitch utilizing double patterning or double exposure has been proposed to deal with a demand for an increase in complexity and density of devices (see Non-patent Document 1, for example).

Non-patent Document 1 discloses forming 32 nm lines at a pitch of 1:3, followed by etching. 32 nm lines are formed at a pitch of 1:3 at positions displaced from the first-layer resist pattern by a half pitch, followed by etching to obtain 32 nm lines at a 1:1 pitch.

### RELATED-ART DOCUMENT

### PATENT DOCUMENT

Patent Document 1: Japanese Patent Application Publication (KOKAI) No. 5-232704
Patent Document 2: Japanese Patent Application Publication (KOKAI) No. 10-303114

### NON-PATENT DOCUMENT

Non-patent Document 1: SPIE 2006, Vol. 6153 61531K

### SUMMARY OF THE INVENTION

However, specific and practical methods, materials, and the like that improve the above processes have not been proposed.

The invention was conceived in view of the above problems. An object of the invention is to provide a resist pattern coating agent that can suppress LWR and a top loss when forming a resist pattern. Another object of the invention is to provide a resist pattern-forming method that can conveniently and efficiently form a fine resist pattern.

The inventors conducted extensive studies in order to achieve the above objects. As a result, the inventors found that the above objects can be achieved by utilizing a resist pattern coating agent that includes a specific solvent. The inventors also found that the above objects can be achieved by a resist pattern-forming method that includes insolubilizing a first resist pattern formed using a first radiation-sensitive resin composition. These findings have led to the completion of the invention.

Specifically, the invention provides a resist pattern coating agent and a resist pattern-forming method given below.

[1] A resist pattern coating agent including a hydroxyl group-containing resin, and a solvent that includes an alcohol shown by the following general formula (1): R-OH (wherein R represents a branched alkyl group having 3 to 10 carbon atoms) in an amount of 30 mass% or more, the resist pattern coating agent being used in a step (2) of a resist pattern-forming method that includes (1) forming a first resist pattern on a substrate using a first radiation-sensitive resin composition (hereinafter may be referred to as "step (1)"), (2) treating the first resist pattern with the resist pattern coating agent (hereinafter may be referred to as "step (2)"), and (3) forming a second resist pattern on the substrate treated with the resist pattern coating agent using a second radiation-sensitive resin composition (hereinafter may be referred to as "step (3)").

[2] The resist pattern coating agent according to [1], wherein the hydroxyl group-containing resin has been obtained by polymerizing a monomer component that includes a monomer shown by the following general formula (2),

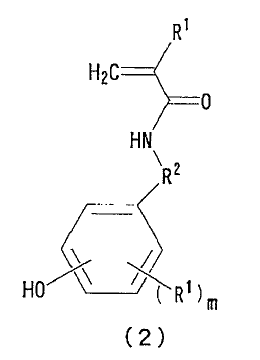

wherein R¹ individually represent a hydrogen atom or a methyl group, R² represents a single bond or a linear, branched, or cyclic divalent hydrocarbon group, and m is 1 or 2.

[3] The resist pattern coating agent according to [1] or [2], wherein the hydroxyl group-containing resin has been obtained by polymerizing a monomer component that includes at least one of hydroxyacrylanilide and hydroxymethacrylanilide.

[4] A resist pattern-forming method including (1) forming a first resist pattern on a substrate using a first radiation-sensitive resin composition (hereinafter may be referred to as "step (1)"), (2) treating the first resist pattern with the resist pattern coating agent according to any one of [1] to [3] (hereinafter may be referred to as "step (2)"), and (3) forming a second resist pattern on the substrate treated with the resist pattern coating agent using a second radiation-sensitive resin composition (hereinafter may be referred to as "step (3)").

The above resist pattern coating agent suppresses LWR and a top loss when forming a resist pattern, and allows a fine resist pattern to be conveniently and efficiently formed.

The above pattern-forming method can conveniently and efficiently form a fine resist pattern.

### BRIEF DESCRIPTION OF THE DRAWINGS

FIG. 1 is a cross-sectional view showing an example of a step (1) of a resist pattern-forming method according to one embodiment of the invention (i.e., a state in which a first resist pattern is formed on a substrate).
FIG. 2 is a cross-sectional view showing an example of a step (2) of a resist pattern-forming method according to one embodiment of the invention (i.e., a state in which a first resist pattern has been insolubilized).
FIG. 3 is a schematic view showing an example of a step (2) of a resist pattern-forming method according to one embodiment of the invention (i.e., a state in which a first resist pattern has been insolubilized).
FIG. 4 is a cross-sectional view showing an example of a step (3) of a resist pattern-forming method according to one embodiment of the invention (i.e., a state in which a second resist layer is formed on an insolubilized resist pattern).
FIG. 5 is a schematic view showing an example of a step (3) of a resist pattern-forming method according to one embodiment of the invention (i.e., a state in which a second resist pattern is formed).
FIG. 6 is a schematic view showing another example of a step (3) of a resist pattern-forming method according to one embodiment of the invention (i.e., a state in which a second resist pattern is formed).
FIG. 7 is a schematic view showing still another example of a step (3) of a resist pattern-forming method according to one embodiment of the invention (i.e., a state in which a second resist pattern is formed).
FIG. 8 is a side view showing an example of a step (3) of a resist pattern-forming method according to one embodiment of the invention (i.e., a state in which a second resist pattern is formed).

### DESCRIPTION OF EXEMPLARY EMBODIMENTS

Exemplary embodiments of the invention are described below. Note that the invention is not limited to the following embodiments. Various modifications and improvements may be made of the following embodiments without departing from the scope of the invention based on the knowledge of a person having ordinary skill in the art. Note that the term "resist pattern coating agent" may be referred to as "coating agent".

### I. Resist pattern coating agent

A resist pattern coating agent according to one embodiment of the invention is used to insolubilize a first resist pattern in a resist pattern-forming method according to one embodiment of the invention, and includes a hydroxyl group-containing resin, and a solvent.

### 1. Hydroxyl group-containing resin

The hydroxyl group-containing resin is preferably a resin that is obtained by polymerizing a monomer component that includes a monomer shown by the following general formula (2).

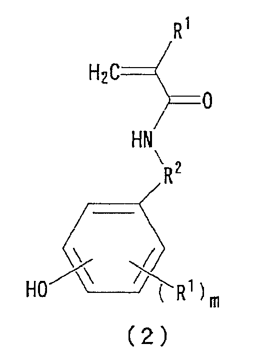

wherein R¹ individually represent a hydrogen atom or a methyl group, R² represents a single bond or a linear, branched, or cyclic divalent hydrocarbon group, and m is 1 or 2.

Specific examples of the divalent linear, branched, or cyclic hydrocarbon group represented by R² in the general formula (2) include chain-like hydrocarbon groups such as a methylene group, an ethylene group, a propylene group (e.g., 1,3-propylene group and 1,2-propylene group), a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an icosylene group, a 1-methyl-1,3-propylene group, a 2-methyl-1,3-propylene group, a 2-methyl-1,2-propylene group, a 1-methyl-1,4-butylene group, a 2-methyl-1,4-butylene group, an ethylidene group, a 1-propylidene group, and a 2-propylidene group; monocyclic hydrocarbon groups such as a cycloalkylene group having 3 to 10 carbon atoms, such as a cyclobutylene group (e.g., 1,3-cyclobutylene group), a cyclopentylene group (e.g., 1,3-cyclopentylene group), a cyclohexylene group (e.g., 1,4-cyclohexylene group), and a cyclooctylene group (e.g., 1,5-cyclooctylene group); bridged cyclic hydrocarbon groups such as a dicyclic to tetracyclic hydrocarbon group having 4 to 30 carbon atoms, such as a norbornylene group (e.g., 1,4-norbornylene group and 2,5-norbornylene group), and an adamantylene group (e.g., 1,5-adamantylene group and 2,6-adamantylene group); and the like. The hydroxyl group-containing resin is preferably a resin that is obtained by polymerizing a monomer component that includes at least one of hydroxyacrylanilide and hydroxymethacrylanilide (hereinafter referred to as "hydroxy(meth)acrylanilide") as the monomer shown by the general formula (2).

The monomer shown by the general formula (2) is normally used in an amount of 30 to 95 mol%, and preferably 40 to 90 mol%, based on the total amount (=100 mol%) of the monomer component.

The hydroxyl group-containing resin may be a resin that is obtained by polymerizing a monomer component that includes at least one of a monomer shown by the following general formula (3-1) and a monomer shown by the following general formula (3-2) (hereinafter collectively referred to as "monomer (3)").

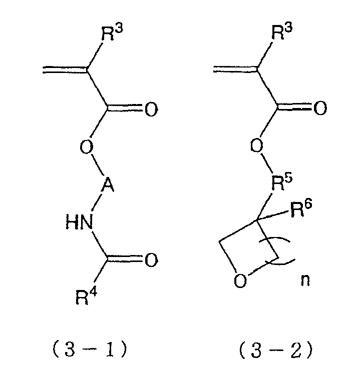

wherein R³ represents a hydrogen atom, a methyl group, or a trifluoromethyl group, A represents a methylene group, an ethylene group, or a propylene group, R⁴ represents a group shown by the following formula (4-1) or a group shown by the following formula (4-2), R⁵ represents a methylene group or an alkylene group having 2 to 6 carbon atoms, R⁶ represents a hydrogen atom, a methyl group, or an ethyl group, and n is 0 or 1.

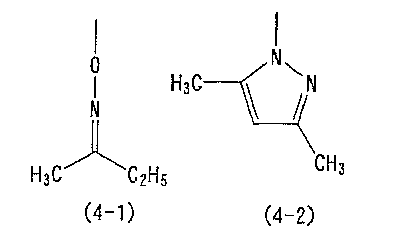

### (ii) Monomer (3)

Examples of the monomer (3) include glycidyl methacrylate, glycidyl acrylate, (1-ethyl-1-oxetanyl)methyl methacrylate ("OXMA" manufactured by Ube Industries, Ltd.), 2-[(3,5-dimethylpyrazolyl)carbonylamino]ethyl methacrylate ("MOI-BP" manufactured by Showa Denko K.K.), 2-[0-(1-methylpropylideneamino)carbonylamino]ethyl methacrylate ("MOI-BM" manufactured by Showa Denko K.K.), and the like.

The monomer (3) is normally used in an amount of 5 to 60 mol%, preferably 5 to 50 mol%, and more preferably 5 to 40 mol%, based on the total amount (=100 mol%) of the monomer component.

The hydroxyl group-containing resin is preferably a resin that is obtained by polymerizing a monomer component that includes a monomer shown by the following general formula (5) (hereinafter referred to as "monomer (5)").

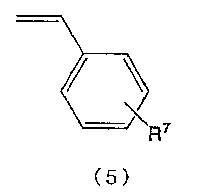

wherein R⁷ represents a hydrogen atom, a linear or branched alkyl group having 1 to 8 carbon atoms, a linear or branched alkoxy group having 1 to 8 carbon atoms, or an acetoxy group.

### (iii) Monomer (5)

R⁷ in the general formula (5) preferably represents a t-butoxy group, an acetoxy group, or a 1-ethoxyethoxy group, and particularly preferably represents a t-butoxy group.

The monomer (5) is a styrene derivative, and preferably a monomer that includes a specific functional group that can be converted into a phenolic hydroxyl group after copolymerization (hereinafter referred to as "specific functional group-containing monomer"). Specific examples of the specific functional group-containing monomer include p-acetoxystyrene, α-methyl-p-acetoxystyrene, p-benzyloxystyrene, p-t-butoxystyrene, p-t-butoxycarbonyloxystyrene, p-t-butyldimethylsiloxystyrene, and the like. The specific functional group can be easily converted into a phenolic hydroxyl group by copolymerizing the specific functional group-containing monomer with another monomer, and subjecting the resulting copolymer to an appropriate treatment (e.g., hydrolysis using hydrochloric acid).

The monomer (5) is normally used in an amount of 5 to 65 mol%, and preferably 10 to 50 mol%, based on the total amount (=100 mol%) of the monomer component.

The monomer component that is polymerized to produce the hydroxyl group-containing resin preferably further includes at least one monomer (hereinafter referred to as "additional monomer") selected from the group consisting of a monomer that includes an alcoholic hydroxyl group (hereinafter referred to as "monomer (6)"), a monomer that includes a hydroxyl group derived from an organic acid (e.g., carboxylic acid) (hereinafter referred to as "monomer (7)"), and a monomer that includes a phenolic hydroxyl group (hereinafter referred to as "monomer (8)"). Note that the monomer (8) excludes hydroxy(meth)acrylanilide.

### (iv) Monomer (6)

Specific examples of the monomer (6) include hydroxyalkyl (meth)acrylates such as 2-hydroxyethyl acrylate, 2-hydroxyethyl methacrylate, 2-hydroxypropyl acrylate, 2-hydroxypropyl methacrylate, 4-hydroxybutyl acrylate, 4-hydroxybutyl methacrylate, and glycerol monomethacrylate, and the like. Among these, 2-hydroxyethyl acrylate and 2-hydroxyethyl methacrylate are preferable. These monomers (6) may be used either individually or in combination.

The monomer (6) is normally used in an amount of 5 to 65 mol%, and preferably 10 to 60 mol%, based on the total amount (=100 mol%) of the monomer component.

### (v) Monomer (7)

Specific examples of the monomer (7) include (meth)acrylic acid and (meth)acrylic acid derivatives such as monocarboxylic acids such as acrylic acid, methacrylic acid, crotonic acid, 2-succinoloylethyl (meth)acrylate, 2-maleinoloylethyl (meth)acrylate, 2-hexahydrophthaloylethyl (meth)acrylate, ω-carboxypolycaprolactone monoacrylate, monohydroxyethyl phthalate acrylate, an acrylic acid dimer, 2-hydroxy-3-phenoxypropyl acrylate, t-butoxy methacrylate, and t-butyl acrylate, and dicarboxylic acids such as maleic acid, fumaric acid, citraconic acid, mesaconic acid, and itaconic acid, and the like. Among these, acrylic acid, methacrylic acid, and 2-hexahydrophthaloylethyl methacrylate are preferable. These monomers (7) may be used either individually or in combination.

The monomer (7) is normally used in an amount of 5 to 65 mol%, and preferably 10 to 60 mol%, based on the total amount (=100 mol%) of the monomer component.

A commercially available product may be used as the monomer (7). For example, ω-carboxy-polycaprolactone monoacrylate is commercially available as Aronix M-5300 (manufactured by Toagosei Co., Ltd.). An acrylic acid dimer is commercially available as Aronix M-5600 (manufactured by Toagosei Co., Ltd.). 2-Hydroxy-3-phenoxypropyl acrylate is commercially available as Aronix M-5700 (manufactured by Toagosei Co., Ltd.).

### (vi) Monomer (8)

Specific examples of the monomer (8) include p-hydroxystyrene, m-hydroxystyrene, o-hydroxystyrene, α-methyl-p-hydroxystyrene, α-methyl-m-hydroxystyrene, α-methyl-o-hydroxystyrene, 2-allylphenol, 4-allylphenol, 2-allyl-6-methylphenol, 2-allyl-6-methoxyphenol, 4-allyl-2-methoxyphenol, 4-allyl-2,6-dimethoxyphenol, 4-allyloxy-2-hydroxybenzophenone, and the like. Among these, p-hydroxystyrene and α-methyl-p-hydroxystyrene are preferable.

The monomer (8) is normally used in an amount of 5 to 65 mol%, preferably 5 to 50 mol%, and more preferably 5 to 45 mol%, based on the total amount (=100 mol%) of the monomer component.

The additional monomer is used in an amount within the above range. If the amount of the additional monomer is too small, the resist pattern may shrink since a reaction site with a crosslinking component (described later) may be insufficient. If the amount of the additional monomer is too large, swelling may occur during development, so that the resist pattern may be buried. Specifically, if the amount of the additional monomer is outside the above range, it may be difficult to suppress a change in line width of the insolubilized resist pattern formed using the coating agent.

The monomer component may further include a further monomer in order to control the hydrophilicity and the solubility of the resin.

### (vii) Further monomer

Examples of the further monomer include aryl (meth)acrylates, dicarboxylic diesters, nitrile group-containing polymerizable compounds, amide bond-containing polymerizable compounds, vinyl compounds, allyl compounds, chlorine-containing polymerizable compounds, conjugated diolefins, and the like. Specific examples of the further monomer include dicarboxylic diesters such as diethyl maleate, diethyl fumarate, and diethyl itaconate; aryl (meth)acrylates such as phenyl (meth)acrylate and benzyl (meth)acrylate; (meth)acrylates such as t-butyl (meth)acrylate and 4,4,4-trifluoro-3-hydroxy-1-methyl-3-trifluoromethyl-1-butyl (meth)acrylate; nitrile group-containing polymerizable compounds such as acrylonitrile and methacrylonitrile; amide bond-containing polymerizable compounds such as acrylamide and methacrylamide; fatty-acid vinyl compounds such as vinyl acetate; chlorine-containing polymerizable compounds such as vinyl chloride and vinylidene chloride; and conjugated diolefins such as 1,3-butadiene, isoprene, and 1,4-dimethylbutadiene. These further monomers may be used either individually or in combination.

Specific examples of a preferable further monomer include a compound shown by the following general formula (6).

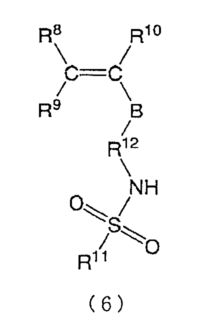

wherein R⁸ to R¹⁰ individually represent a hydrogen atom, an alkyl group having 1 to 10 carbon atoms, a hydroxymethyl group, a trifluoromethyl group, or a phenyl group, R¹¹ represents a monovalent organic group, R¹² represents a single bond or a divalent organic group having 1 to 20 carbon atoms, and B represents a single bond, an oxygen atom, a carbonyl group, a carbonyloxy group, or an oxycarbonyl group.

Specific examples of the alkyl group having 1 to 10 carbon atoms represented by R⁸ to R¹⁰ in the general formula (6) include a methyl group, an ethyl group, a propyl group, a butyl group, a pentyl group, a hexyl group, a heptyl group, an octyl group, a nonyl group, a decyl group, and the like. It is preferable that R⁸ and R⁹ represent a hydrogen atom, and R¹⁰ represent a hydrogen atom or a methyl group.

The monovalent organic group represented by R¹¹ in the general formula (6) is preferably a monovalent organic group that includes a fluorine atom, more preferably a fluoroalkyl group having 1 to 20 carbon atoms, and particularly preferably a fluoroalkyl group having 1 to 4 carbon atoms.

Specific examples of the fluoroalkyl group having 1 to 20 carbon atoms include a difluoromethyl group, a perfluoromethyl group, a 1,1-difluoroethyl group, a 2,2-difluoroethyl group, a 2,2,2-trifluoroethyl group, a perfluoroethyl group, a 1,1,2,2-tetrafluoropropyl group, a 1,1,2,2,3,3-hexafluoropropyl group, a perfluoroethylmethyl group, a 1-(trifluoromethyl)-1,2,2,2-tetrafluoroethyl group, a perfluoropropyl group, a 1,1,2,2-tetrafluorobutyl group, a 1,1,2,2,3,3-hexafluorobutyl group, a 1,1,2,2,3,3,4,4-octafluorobutyl group, a perfluorobutyl group, a 1,1-bis(trifluoro)methyl-2,2,2-trifluoroethyl group, a 2-(perfluoropropyl)ethyl group, a 1,1,2,2,3,3,4,4-octafluoropentyl group, a perfluoropentyl group, a 1,1,2,2,3,3,4,4,5,5-decafluoropentyl group, a 1,1-bis(trifluoromethyl)-2,2,3,3,3-pentafluoropropyl group, a perfluoropentyl group, a 2-(perfluorobutyl)ethyl group, a 1,1,2,2,3,3,4,4,5,5-decafluorohexyl group, a 1,1,2,2,3,3,4,4,5,5,6,6-dodecafluorohexyl group, a perfluoropentylmethyl group, a perfluorohexyl group, a 2-(perfluoropentyl)ethyl group, a 1,1,2,2,3,3,4,4,5,5,6,6-dodecafluoroheptyl group, a perfluorohexylmethyl group, a perfluoroheptyl group, a 2-(perfluorohexyl)ethyl group, a 1,1,2,2,3,3,4,4,5,5,6,6,7,7-tetradecafluorooctyl group, a perfluoroheptylmethyl group, a perfluorooctyl group, a 2-(perfluoroheptyl)ethyl group, a 1,1,2,2,3,3,4,4,5,5,6,6,7,7,8,8-hexadecafluorononyl group, a perfluorooctylmethyl group, a perfluorononyl group, a 2-(perfluorooctyl)ethyl group, a 1,1,2,2,3,3,4,4,5,5,6,6,7,7,8,8,9,9-octadecafluorodecyl group, a perfluorononylmethyl group, a perfluorodecyl group, and the like.

If the number of carbon atoms of the fluoroalkyl group is too large, the solubility of the resin in an alkaline solution may decrease. Therefore, a perfluoromethyl group, a perfluoroethyl group, and a perfluoropropyl group are preferable.

Specific examples of the divalent organic group having 1 to 20 carbon atoms represented by R¹² in the general formula (6) include chain-like hydrocarbon groups such as a methylene group, an ethylene group, a propylene group (e.g., 1,3-propylene group and 1,2-propylene group), a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an icosylene group, a 1-methyl-1,3-propylene group, a 2-methyl-1,3-propylene group, a 2-methyl-1,2-propylene group, a 1-methyl-1,4-butylene group, a 2-methyl-1,4-butylene group, a 1,1-ethylidene group, a 1,2-ethylidene group, a 1-propylidene group, and a 2-propylidene group; monocyclic hydrocarbon groups such as a cycloalkylene group having 3 to 10 carbon atoms, such as a cyclobutylene group (e.g., 1,3-cyclobutylene group), a cyclopentylene group (e.g., 1,3-cyclopentylene group), a cyclohexylene group (e.g., 1,4-cyclohexylene group), and a cyclooctylene group (e.g., 1,5-cyclooctylene group); bridged cyclic hydrocarbon groups such as a dicyclic to tetracyclic hydrocarbon group having 4 to 20 carbon atoms, such as a norbornylene group (e.g., 1,4-norbornylene group and 2,5-norbornylene group) and an admantylene group (e.g., 1,5-admantylene group and 2,6-admantylene group); and the like.

Further examples of a preferable monomer shown by the general formula (6) include 2-(((trifluoromethyl)sulfonyl)amino)ethyl-1-methacrylate, 2-(((trifluoromethyl)sulfonyl)amino)ethyl-1-acrylate, and the compounds shown by the following formulas (6-1) to (6-6).

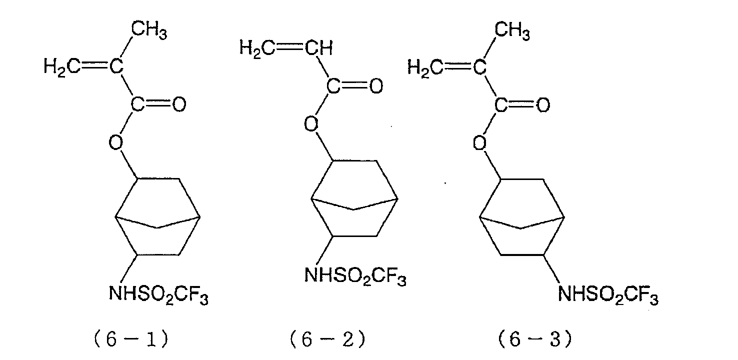

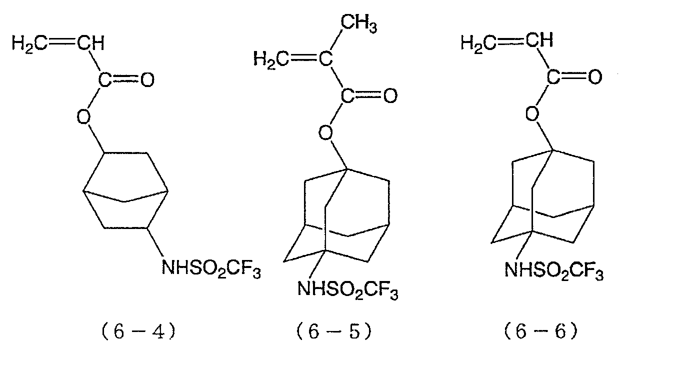

The further monomer is normally used in an amount of 1 to 50 mol%, preferably 2 to 30 mol%, and more preferably 2 to 20 mol%, based on the total amount (=100 mol%) of the monomer component.

### (Production method)

The hydroxyl group-containing resin may be produced by polymerizing the monomer component in an appropriate solvent optionally in the presence of a chain transfer agent using a radical initiator (e.g., hydroperoxide, dialkyl peroxide, diacyl peroxide, or azo compound), for example.

Examples of the solvent used for polymerization include alkanes such as n-pentane, n-hexane, n-heptane, n-octane, n-nonane, and n-decane; cycloalkanes such as cyclohexane, cycloheptane, cyclooctane, decalin, and norbornane; aromatic hydrocarbons such as benzene, toluene, xylene, ethylbenzene, and cumene; halogenated hydrocarbons such as chlorobutane, bromohexane, dichloroethane, hexamethylene dibromide, and chlorobenzene; saturated carboxylates such as ethyl acetate, n-butyl acetate, i-butyl acetate, methyl propionate, and propylene glycol monomethyl ether acetate; alkyllactones such as gamma-butyrolactone; ethers such as tetrahydrofuran, dimethoxyethanes, and diethoxyethane; alkylketones such as 2-butanone, 2-heptanone, and methyl isobutyl ketone; cycloalkylketones such as cyclohexanone; alcohols such as 2-propanol, 1-butanol, 4-methyl-2-pentanol, and propylene glycol monomethyl ether; and the like. These solvents may be used either individually or in combination.

The reaction temperature is normally 40 to 120°C, and preferably 50 to 100°C. The reaction time is normally 1 to 48 hours, and preferably 1 to 24 hours.

It is preferable that the hydroxyl group-containing resin have a high purity. Specifically, it is preferable that the hydroxyl group-containing resin have a low impurity (e.g., halogen or metal) content and a low residual monomer/oligomer content (e.g., 0.1 mass% or less (determined by HPLC)). The process stability and the accuracy of the shape of the resist pattern can be improved using a coating agent that includes a high-purity hydroxyl group-containing resin.

The hydroxyl group-containing resin may be purified as follows, for example. Specifically, impurities (e.g., metals) may be removed by causing metals included in the polymer solution to be adsorbed on a zeta-potential filter, or washing the polymer solution with an acidic aqueous solution (e.g., oxalic acid or sulfonic acid aqueous solution) to remove metals in a chelate state, for example. The residual monomer/oligomer content may be reduced to a value equal to or lower than a given value by liquid-liquid extraction that removes residual monomers and oligomers by washing with water or combining appropriate solvents, purification in a solution state (e.g., ultrafiltration) that extracts and removes only components having a molecular weight equal to or less than a given value, reprecipitation that removes residual monomers and the like by adding the polymer solution to a poor solvent dropwise so that the hydroxyl group-containing resin coagulates in the poor solvent, purification in a solid state that washes the hydroxyl group-containing resin collected by filtration with a poor solvent, or the like. These methods may be used in combination.

### (Properties)

The polystyrene-reduced weight average molecular weight (Mw) of the hydroxyl group-containing resin determined by gel permeation chromatography (GPC) is normally 1000 to 500,000, preferably 1000 to 50,000, and still more preferably 1000 to 20,000. If the Mw of the hydroxyl group-containing resin exceeds 500,000, it may be difficult to remove the thermally cured resin using a developer. If the Mw of the hydroxyl group-containing resin is less than 1000, it may be difficult to form a uniform film.

### 2. Solvent

The solvent included in the coating agent according to one embodiment of the invention includes an alcohol shown by the following general formula (1): R-OH (wherein R represents a branched alkyl group having 3 to 10 carbon atoms) (hereinafter referred to as "branched alkyl alcohol"), can sufficiently dissolve the hydroxyl group-containing resin and an optional crosslinking component, and does not dissolve a first resist pattern formed using a first radiation-sensitive resin composition.

The solvent is preferably used in the coating agent in an amount of 80 mass% or more, and more preferably 90 mass% or more.

The water content in the solvent is preferably 10 mass% or less, and more preferably 3 mass% or less. If the water content in the solvent exceeds 10 mass%, the solubility of the hydroxyl group-containing resin may decrease. The solvent is particularly preferably a non-aqueous solvent (i.e., an absolute alcohol solvent that does not substantially contain water).

### (1) Branched alkyl alcohol

Specific examples of the branched alkyl alcohol include isopropyl alcohol, 2-butanol, t-butyl alcohol, 2-pentanol, 3-pentanol, 2-methyl-1-butanol, 3-methyl-1-butanol, 3-methyl-2-butanol, 2-hexanol, 3-hexanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 2-heptanol, 2-methyl-2-heptanol, 2-methyl-3-heptanol, 2-ethylhexanol, 2,3-dimethyl-3-heptanol, 3-methyl-3-octanol, 4-methyl-4-octanol, 3,5,5-trimethyl-1-hexanol, 2,2-dimethyl-3-octanol, 3,7-dimethyl-3-octanol, 4,7-dimethyl-4-octanol, 4-ethyl-2-octanol, 4-ethyl-3-octanol, 3-methyl-3-nonanol, 4-methyl-4-nonanol, 5-methyl-5-nonanol, 4-n-propyl-4-heptanol, 2,4,6-trimethyl-4-heptanol, and the like. Among these, 2-pentanol, 3-pentanol, 2-methyl-1-butanol, t-butyl alcohol, 4-methyl-1-pentanol, 4-methyl-2-pentanol, and 2-methyl-3-heptanol are preferable. These branched alkyl alcohols may be used either individually or in combination.

The content of the branched alkyl alcohol in the solvent is 30 mass% or more, preferably 40 mass% or more, and more preferably 50 mass% or more. If the content of the branched alkyl alcohol in the solvent is less than 30 mass%, LWR and a top loss may not be sufficiently suppressed. The upper limit of the content of the branched alkyl alcohol in the solvent is not particularly limited, but is preferably 90 mass% or less.

### (2) Linear alkyl alcohol

The solvent may include a linear alkyl alcohol in addition to the branched alkyl alcohol. A monohydric alcohol having 1 to 8 carbon atoms is preferable as the linear alkyl alcohol. Specific examples of the linear alkyl alcohol include 1-propanol, 1-butanol, 1-pentanol, 1-hexanol, and the like.

The solvent may include an additional solvent other than the alcohol in order to adjust the applicability of the coating agent when applying the coating agent to the first resist pattern. The additional solvent is preferably a compound that allows uniform application of the coating agent without dissolving the first resist pattern.

### (3) Additional solvent

Specific examples of the additional solvent include cyclic ethers such as tetrahydrofuran and dioxane; alkyl ethers of polyhydric alcohols such as ethylene glycol monomethyl ether, ethylene glycol monoethyl ether, ethylene glycol dimethyl ether, ethylene glycol diethyl ether, diethylene glycol monomethyl ether, diethylene glycol monoethyl ether, diethylene glycol dimethyl ether, diethylene glycol diethyl ether, diethylene glycol ethyl methyl ether, propylene glycol monomethyl ether, and propylene glycol monoethyl ether; alkyl ether acetates of polyhydric alcohols such as ethylene glycol ethyl ether acetate, diethylene glycol ethyl ether acetate, propylene glycol ethyl ether acetate, and propylene glycol monomethyl ether acetate; aromatic hydrocarbons such as toluene and xylene; ketones such as acetone, methyl ethyl ketone, methyl isobutyl ketone, cyclohexanone, 4-hydroxy-4-methyl-2-pentanone, and diacetone alcohol; esters such as ethyl acetate, butyl acetate, ethyl 2-hydroxypropionate, ethyl 2-hydroxy-2-methylpropionate, ethoxyethyl acetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, ethyl acetate, and butyl acetate; water; and the like. Among these, cyclic ethers, alkyl ethers of polyhydric alcohols, alkyl ether acetates of polyhydric alcohols, ketones, esters, and water are preferable.

The additional solvent is normally used in an amount of 30 mass% or less, and preferably 20 mass% or less, based on the total amount (=100 mass%) of the solvent.
If the amount of the additional solvent exceeds 30 mass%, the first resist pattern may be dissolved, so that intermixing with the coating agent may occur (i.e., the first resist pattern may be buried), for example. When the additional solvent is water, water is preferably used in an amount of 10 mass% or less.

### 3. Crosslinking component

The coating agent according to one embodiment of the invention may optionally include a crosslinking component. The crosslinking component reacts with the hydroxyl group-containing resin and/or another crosslinking component due to an acid, so that the hydroxyl group-containing resin is cured.

When the coating agent includes the crosslinking component, the crosslinking component is preferably used in an amount of 1 to 100 parts by mass, and more preferably 5 to 70 parts by mass, based on 100 parts by mass of the hydroxyl group-containing resin. If the amount of the crosslinking component is less than 1 part by mass, the hydroxyl group-containing resin may not be sufficiently cured, so that the resist pattern may not shrink. If the amount of the crosslinking component exceeds 100 parts by mass, the hydroxyl group-containing resin may be cured to a large extent, so that the resist pattern may be buried.

The total content of the hydroxyl group-containing resin and the crosslinking component in the coating agent is preferably 0.1 to 30 mass%, and more preferably 1 to 20 mass%. If the total content of the hydroxyl group-containing resin and the crosslinking component is less than 0.1 mass%, the resulting film may break at the pattern edge due to a decrease in thickness. If the total content of the hydroxyl group-containing resin and the crosslinking component exceeds 30 mass%, the viscosity of the coating agent may increase to a large extent, so that it may be difficult to embed the coating agent in a fine pattern.

The crosslinking component preferably includes a compound that includes a group shown by the following general formula (7) (hereinafter referred to as "crosslinking component (1)"), or a compound that includes two or more cyclic ethers as reactive groups (hereinafter referred to as "crosslinking component (2)"). It is also preferable that the crosslinking component include both the crosslinking component (1) and the crosslinking component (2).

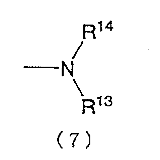

wherein R¹³ and R¹⁴ represent a hydrogen atom or a group shown by the following general formula (8), provided that at least one of R¹³ and R¹⁴ represents a group shown by the general formula (8).

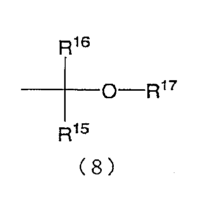

wherein R¹⁵ and R¹⁶ individually represent a hydrogen atom, an alkyl group having 1 to 6 carbon atoms, or an alkoxyalkyl group having 1 to 6 carbon atoms, or bond to form a ring having 2 to 10 carbon atoms, and R¹⁷ represents a hydrogen atom or an alkyl group having 1 to 6 carbon atoms.

### (1) Crosslinking component (1)

Examples of the crosslinking component (1) include compounds including a functional group such as an imino group, a methylol group, or a methoxymethyl group in the molecule. Specific examples of these compounds include nitrogen-containing compounds obtained by alkyl-etherification of all or some of the active methylol groups of (poly)methylolated melamine, (poly)methylolated glycoluril, (poly)methylolated benzoquanamine, (poly)methylolated urea, or the like.

Specific examples of the alkyl group include a methyl group, an ethyl group, a butyl group, and a combination thereof. The nitrogen-containing compound may include an oligomer component that is partially self-condensed. Specific examples of such a compound include hexamethoxymethylated melamine, hexabutoxymethylated melamine, tetramethoxymethylated glycoluril, tetrabutoxymethylated glycoluril, and the like.

A commercially available product may be used as the crosslinking component (1). Examples of commercially available products of the crosslinking component (1) include Cymel 300, Cymel 301, Cymel 303, Cymel 350, Cymel 232, Cymel 235, Cymel 236, Cymel 238, Cymel 266, Cymel 267, Cymel 285, Cymel 1123, Camel 1123-10, Cymel 1170, Cymel 370, Cymel 771, Cymel 272, Cymel 1172, Cymel 325, Cymel 327, Cymel 703, Cymel 712, Cymel 254, Cymel 253, Cymel 212, Cymel 1128, Cymel 701, Cymel 202, and Cymel 207 (manufactured by Nihon Cytec Industries, Inc.), Nikalac MW-30M, Nikalac MW-30, Nikalac MW-22, Nikalac MW-24X, Nikalac MS-21, Nikalac MS-11, Nikalac MS-001, Nikalac MX-002, Nikalac MX-730, Nikalac MX-750, Nikalac MX-708, Nikalac MX-706, Nikalac MX-042, Nikalac MX-035, Nikalac MX-45, Nikalac MX-410, Nikalac MX-302, Nikalac MX-202, Nikalac SM-651, Nikalac SM-652, Nikalac SM-653, Nikalac SM-551, Nikalac SM-451, Nikalac SB-401, Nikalac SB-355, Nikalac SB-303, Nikalac SB-301, Nikalac SB-255, Nikalac SB-203, Nikalac SB-201, Nikalac BX-4000, Nikalac BX-37, Nikalac BX-55H, and Nikalac BL-60 (manufactured by Sanwa Chemical Co., Ltd.), Aron Oxetane OXT-101, OXT-121, OXT-221 (manufactured by Toagosei Co., Ltd.), OXTP, OXBP (manufactured by Ube Industries, Ltd.), and the like. Among these, Cymel 325,Cymel 327, Cymel 703, Cymel 712, Cymel 254, Cymel 253, Camel 212, Cymel 1128, Cymel 701, Cymel 202, Cymel 207, and Nikalac MX-750 (corresponding to the compound shown by the general formula (7) wherein R¹³ or R¹⁴ represents a hydrogen atom (i.e., imino group)) are preferable.

### (2) Crosslinking component (2)

Specific examples of the crosslinking component (2) include epoxycyclohexyl group-containing compounds such as 3,4-epoxycyclohexylmethyl-3',4'-epoxycyclohexane carboxylate, 2-(3,4-epoxycyclohexyl-5,5-spiro-3,4-epoxy)cyclohexane-m-dioxane, bis(3,4-epoxycyclohexylmethyl) adipate, bis(3,4-epoxy-6-methylcyclohexylmethyl) adipate, 3,4-epoxy-6-methylcyclohexyl-3',4'-epoxy-6'-methylcyclohexane carboxylate, methylenebis(3,4-epoxycyclohexane), ethylene glycol di(3,4-epoxycyclohexylmethyl) ether, ethylenebis(3,4-epoxycyclohexane carboxylate), epsilon-caprolactone-modified 3,4-epoxycyclohexylmethyl-3',4'-epoxycyclohexane carboxylate, trimethylcaprolactone-modified 3,4-epoxycyclohexylmethyl-3',4'-epoxycyclohexane carboxylate, and β-methyl-delta-valerolactone-modified 3,4-epoxycyclohexylmethyl-3',4'-epoxycyclohexane carboxylate;

bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, hydrogenated bisphenol A diglycidyl ether, hydrogenated bisphenol F diglycidyl ether, hydrogenated bisphenol S diglycidyl ether, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether;

polyglycidyl ethers of a polyether polyol obtained by adding at least one alkylene oxide to an aliphatic polyhydric alcohol (e.g., ethylene glycol, propylene glycol, or glycerol); diglycidyl esters of an aliphatic long-chain dibasic acid; monoglycidyl ethers of an aliphatic higher alcohol; glycidyl esters of a higher fatty acid;

3,7-bis(3-oxetanyl)-5-oxa-nonane, 3,3'-(1,3-(2-methylenyl)propanediylbis(oxymethylene))bis-(3-ethyloxetane), 1,4-bis[(3-ethyl-3-oxetanylmethoxy)methyl]benzene, 1,2-bis[(3-ethyl-3 -oxetanylmethoxy)methyl] ethane, 1,3-bis[(3-ethyl-3-oxetanylmethoxy)methy]propane, ethylene glycol bis(3-ethyl-3-oxetanylmethyl) ether, dicyclopentenyl bis(3-ethyl-3-oxetanylmethyl) ether, triethylene glycol bis(3-ethyl-3-oxetanylmethyl) ether, pentaerythritol tetraacrylate, pentaerythritol triacylate, tetraethylene glycol bis(3-ethyl-3-oxetanylmethyl) ether, tricyclodecanediyldimethylene(3-ethyl-3-oxetanylmethyl) ether, trimethylolpropane tris(3-ethyl-3-oxetanylmethyl) ether, 1,4-bis(3-ethyl-3-oxetanylmethoxy)butane, 1,6-bis(3-ethyl-3-oxetanylmethoxy)hexane, pentaerythritol tris(3-ethyl-3-oxetanylmethyl) ether, pentaerythritol tetrakis(3-ethyl-3-oxetanylmethyl) ether, polyethylene glycol bis(3-ethyl-3-oxetanylmethyl) ether, dipentaerythritol hexakis(3-ethyl-3-oxetanylmethyl) ether, dipentaerythritol pentakis(3-ethyl-3-oxetanylmethyl) ether, dipentaerythritol tetrakis(3-ethyl-3-oxetanylmethyl) ether, caprolactone-modified dipentaerythritol hexakis(3-ethyl-3-oxetanylmethyl) ether, caprolactone-modified dipentaerythritol pentakis(3-ethyl-3-oxetanylmethyl) ether, ditrimethylolpropane tetrakis(3-ethyl-3-oxetanylmethyl) ether, ethylene oxide (EO)-modified bisphenol A bis(3-ethyl-3-oxetanylmethyl) ether, propylene oxide (PO)-modified bisphenol A bis(3-ethyl-3-oxetanylmethyl) ether, EO-modified hydrogenated bisphenol A bis(3-ethyl-3-oxetanylmethyl) ether, PO-modified hydrogenated bisphenol A bis(3-ethyl-3-oxetanylmethyl) ether, EO-modified bisphenol F bis(3-ethyl-3-oxetanylmethyl) ether;

oxetane compounds including two or more oxetane rings in the molecule such as Aron Oxetane OXT-101, Aron Oxetane OXT-121, Aron Oxetane OXT-221 (manufactured by Toagosei Co., Ltd.), and OXTP, OXBP, OXIPA (manufactured by Ube Industries, Ltd.); and the like.

Among these, 1,6-hexanediol diglycidyl ether, dipentaerythritol hexakis(3-ethyl-3-oxetanylmethyl) ether, and OXIPA are preferable. These crosslinking components (2) may be used either individually or in combination.

### 4. Surfactant

The coating agent according to one embodiment of the invention may optionally include a surfactant. The surfactant improves the applicability, defoamability, leveling properties, and the like of the coating agent. Specific examples of the surfactant include fluorine-containing surfactants such as BM-1000, BM-1100 (manufactured by BM Chemie), Megafac F142D, F172, F173, F183 (manufactured by DIC Corporation), Fluorad FC-135, FC-170C, FC-430, FC-431 (manufactured by Sumitomo 3M, Ltd.), Surflon S-112, S-113, S-131, S-141, S-145 (manufactured by Asahi Glass Co., Ltd.), SH-28PA, SH-190, SH-193, SZ-6032, SF-8428 (manufactured by Dow Coming Toray Silicone Co., Ltd.), and the like.

The surfactant is preferably used in an amount of 5 parts by mass or less based on 100 parts by mass of the hydroxyl group-containing resin.

### II. Resist pattern-forming method

A resist pattern-forming method according to one embodiment of the invention includes steps (1) to (3). A resist pattern that includes an insolubilized resist pattern and a second resist pattern can be formed on a substrate by the steps (1) to (3). A semiconductor device can be advantageously produced by utilizing the resist pattern thus formed.

### 1. Step (1)

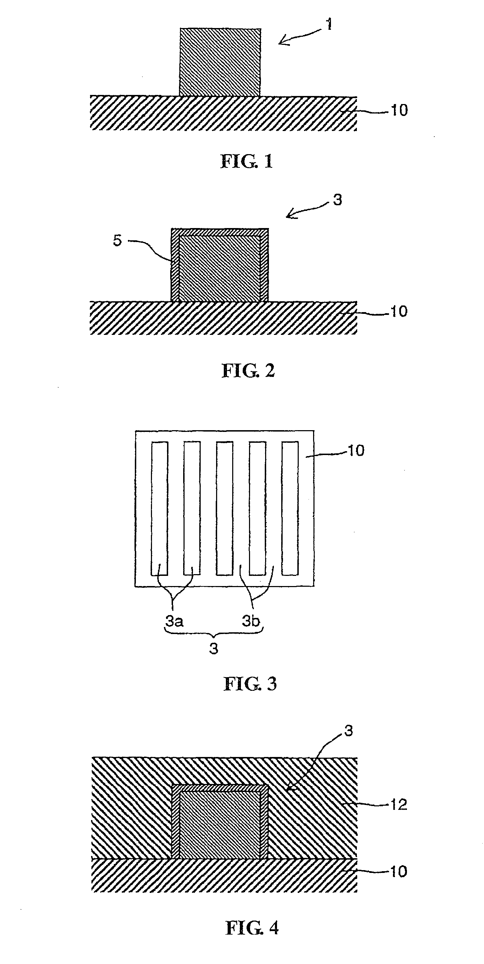

FIG. 1 is a cross-sectional view showing an example of the step (1) of the resist pattern-forming method according to one embodiment of the invention (i.e., a state in which the first resist pattern is formed on the substrate). In the step (1), a first resist layer is formed on a substrate 10 using a first radiation-sensitive resin composition (hereinafter referred to as "first resist material"), selectively exposed via a mask, and developed to form a first resist pattern 1.

### (1) Formation of first resist layer

The first resist layer may be formed by applying the first resist material to the substrate 10 by an appropriate application method (e.g., spin coating, cast coating, or roll coating). After applying the first resist material, the resulting film may optionally be prebaked (PB) to vaporize the solvent. The PB temperature is appropriately selected depending on the composition of the first resist material, but is normally 30 to 200°C, and preferably 50 to 150°C.

A protective film may be formed on the first resist layer in order to prevent an adverse effect of basic impurities and the like present in the environmental atmosphere, as disclosed in Japanese Patent Application Publication (KOKAI) No. 5-188598, for example.

### (i) Substrate

As the substrate, a silicon wafer, a wafer covered with SiN or an organic antireflective film, or the like may be used. In order to bring out the potential of the first resist material to a maximum extent, an organic or inorganic antireflective film may be formed on the substrate, as disclosed in Japanese Examined Patent Publication (KOKOKU) No. 6-12452, for example.

### (ii) First resist material

The first resist material is a resist material described later.

### (2) Exposure

The first resist layer is exposed by applying radiation to the desired area of the first resist layer via a mask having a given pattern to form an alkali-developable area (i.e., an area that has become alkali-soluble due to exposure). Radiation used for exposure is appropriately selected from visible rays, ultraviolet rays, deep ultraviolet rays, X-rays, electron beams, charged particle rays, and the like depending on the type of acid generator included in the first resist material. It is preferable to use deep ultraviolet rays such as ArF excimer laser light (wavelength: 193 nm) and KrF excimer laser light (wavelength: 248 nm). It is particularly preferable to use ArF excimer laser light (wavelength: 193 nm).

The exposure conditions (e.g., dose) are appropriately selected depending on the composition of the first resist material, the type of additive, and the like. It is preferable to perform post-exposure bake (PEB). The acid-dissociable group included in the first resist material dissociates smoothly due to PEB. The PEB temperature is appropriately selected depending on the composition of the first resist material, but is normally 30 to 200°C, and preferably 50 to 170°C.

### (3) Formation of first resist pattern

The exposed first resist layer is developed using a developer, so that the alkali-developable area (i.e., the exposed area of the first resist layer) is dissolved. The first resist pattern 1 shown in FIG. 1 that has a given line width (i.e., has a given space area) is thus formed on the substrate 10. After development using the alkaline aqueous solution, the resist pattern is normally washed with water, and dried.

A developer that may be used for development is preferably an alkaline aqueous solution prepared by dissolving at least one alkaline compound (e.g., sodium hydroxide, potassium hydroxide, sodium carbonate, sodium silicate, sodium metasilicate, ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, or 1,5-diazabicyclo-[4.3.0]-5-nonene) in water. The concentration of the alkaline aqueous solution is normally 10 mass% or less. If the concentration of the alkaline aqueous solution exceeds 10 mass%, the unexposed area may be easily dissolved in the developer.

An organic solvent may be added to the alkaline aqueous solution (developer). Examples of the organic solvent include ketones such as acetone, methyl ethyl ketone, methyl i-butyl ketone, cyclopentanone, cyclohexanone, 3-methylcyclopentanone, and 2,6-dimethylcyclohexanone; alcohols such as methanol, ethanol, n-propyl alcohol, i-propyl alcohol, n-butyl alcohol, t-butyl alcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, dimethylformamide; and the like. These organic solvents may be used either individually or in combination.

The organic solvent is preferably used in an amount of 100 parts by volume or less based on 100 parts by volume of the alkaline aqueous solution. If the amount of the organic solvent exceeds 100 parts by volume, the exposed area may remain undeveloped due to a decrease in developability. An appropriate amount of a surfactant or the like may be added to the developer.

### 2. Step (2)

FIG. 2 is a cross-sectional view showing an example of the step (2) of the resist pattern-forming method according to one embodiment of the invention (i.e., a state in which the first resist pattern has been insolubilized). FIG. 3 is a schematic view showing an example of the step (2) of the resist pattern-forming method according to one embodiment of the invention (i.e., a state in which the first resist pattern has been insolubilized). In the step (2), the first resist pattern is treated with the coating agent according to one embodiment of the invention. Specifically, the coating agent is applied to the first resist pattern 1, baked or UV-cured, and washed so that the first resist pattern 1 is converted into an insolubilized resist pattern 3 that is insoluble in a developer and a second radiation-sensitive resin composition (hereinafter referred to as "second resist material").

The coating agent may be applied to the first resist pattern 1 by an appropriate application method (e.g., rotational coating, cast coating, or roll coating). The coating agent is applied to cover the first resist pattern 1.

The coating agent thus applied is baked or UV-cured. The first resist pattern 1 thus reacts with the coating agent. The heating temperature is appropriately selected depending on the composition of the coating agent, but is normally 30 to 200°C, and preferably 50 to 170°C. The coating agent may be UV-cured using an Ar₂ lamp, a KrCl lamp, a Kr₂ lamp, an XeCl lamp, an Xe₂ lamp (manufactured by Ushio, Inc.), or the like.

After appropriately cooling the coating agent, the coating agent is developed in the same manner as in the step (1) to form an insoluble film 5 of the coating agent on the first resist pattern 1 (see FIG. 2). The insoluble film 5 is insoluble or scarcely soluble in a developer and the second resist material. After development, the insolubilized resist pattern 3 may be repeatedly cured by UV-curing or PEB, as required.

The pattern shape of the insolubilized resist pattern 3 remains even when applying the second resist material to the insolubilized resist pattern 3, and exposing and developing the resulting second resist layer. Note that the line width of the pattern may change to some extent depending on the thickness of the applied coating agent, and the like. The step (2) may optionally be performed a plurality of times.

The insolubilized resist pattern 3 that includes third line areas 3 a and third space areas 3b is thus formed on the substrate 10 (see FIG. 3).

### 3. Step (3)

In the step (3), a second resist layer 12 is formed on the substrate treated with the coating agent using the second resist material. Specifically, a second resist layer 12 is formed on the substrate 10 on which the insolubilized resist pattern 3 is formed using the second resist material, selectively exposed via a mask, and developed to form a second resist pattern.

### (1) Formation of second resist layer

FIG. 4 is a cross-sectional view showing an example of the step (3) of the resist pattern-forming method according to one embodiment of the invention (i.e., a state in which a second resist layer is formed on the insolubilized resist pattern). The second resist layer 12 may be formed on the substrate 10 on which the insolubilized resist pattern 3 is formed by applying the second resist material to the substrate 10 by an appropriate application method (e.g., spin coating, cast coating, or roll coating). The second resist layer 12 may optionally be prebaked (PB) in the same manner as in the step (1).

### (2) Exposure

The second resist layer 12 is selectively exposed via a mask optionally together with the space areas 3b of the insolubilized resist pattern 3 in the same manner as in the step (1). The second resist layer 12 may optionally be subjected to post-exposure bake (PEB).

### (3) Formation of second resist pattern

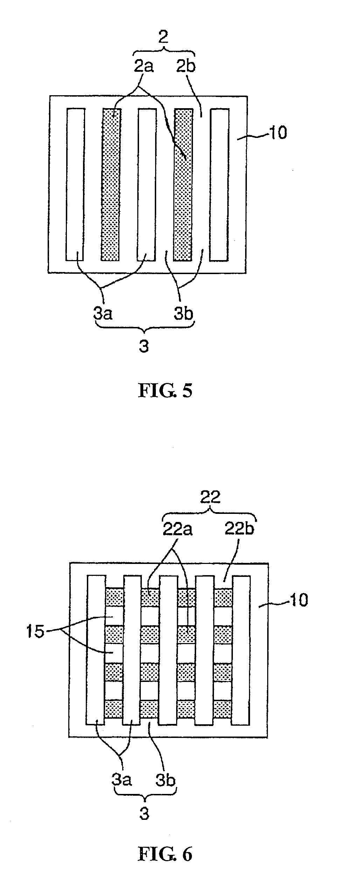

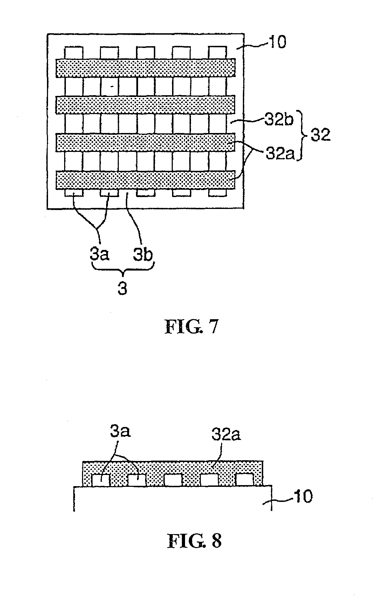

FIGS. 5 to 7 are schematic views showing an example of the step (3) of the resist pattern-forming method according to one embodiment of the invention (i.e., a state in which the second resist pattern is formed). FIG. 8 is a side view showing an example of the step (3) of the resist pattern-forming method according to one embodiment of the invention (i.e., a state in which the second resist pattern is formed). The second resist layer is developed after exposure to form a second resist pattern. The second resist layer may be developed in the same manner as in the step (1).

Various resist patterns having a specific pattern arrangement can be formed by appropriately selecting the pattern of the mask used during exposure in the step (3). As shown in FIG. 5, an insolubilized resist pattern 3 that includes third line areas 3 a and third space areas 3b and a second resist pattern 2 that includes second line areas 2a and second space areas 2b can be formed in parallel on the substrate 10, for example.

As shown in FIG. 6, a resist pattern (contact hole pattern) that includes contact holes 15 defined by the third line areas 3 a and the second line areas 22a can be formed by forming the second line areas 22a of the second resist pattern 22 (that includes the second line areas 22a and the second space areas 22b) in a grid shape in the third space areas 3b of the insolubilized resist pattern 3 (that includes the third line areas 3 a and the third space areas 3b), for example.

As shown in FIGS. 7 and 8, the second line areas 32a of the second resist pattern 32 (that includes the second line areas 32a and the second space areas 32b) may be formed over the third line areas 3 a of the insolubilized resist pattern 3 (that includes the third line areas 3a and the third space areas 3b) so that the second line areas 32a intersect the third line areas 3 a, for example.

### III. Resist material

The resist material is used to form a resist layer, and includes an acid-dissociable group-containing resin, a photoacid generator (hereinafter may be referred to as "acid generator"), and a solvent. When forming a resist layer using the resist material, the acid-dissociable group included in the resin dissociates due to an acid generated by the acid generator upon exposure, so that the solubility of the exposed area in an alkaline developer increases. Therefore, the exposed area is dissolved (removed) in an alkaline developer to obtain a resist pattern. The first resist material used to form the first resist layer and the second resist material used to form the second resist layer may be either the same or different.

### 1. Acid-dissociable group-containing resin

The acid-dissociable group-containing resin preferably includes a repeating unit shown by the following general formula (9).

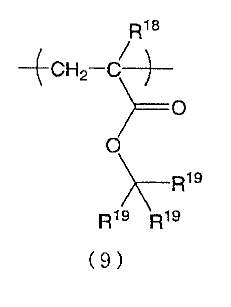

wherein R¹⁸ represents a hydrogen atom or a methyl group, and R¹⁹ individually represent a monovalent alicyclic hydrocarbon group having 4 to 20 carbon atoms, a derivative thereof, or a linear or branched alkyl group having 1 to 4 carbon atoms, provided that at least one of R¹⁹ represents a monovalent alicyclic hydrocarbon group having 4 to 20 carbon atoms or a derivative thereof, or two of R¹⁹ bond to form a divalent alicyclic hydrocarbon group having 4 to 20 carbon atoms, or a derivative thereof, together with the carbon atom that is bonded thereto, and the remaining R¹⁹ represents a linear or branched alkyl group having 1 to 4 carbon atoms, a monovalent alicyclic hydrocarbon group having 4 to 20 carbon atoms, or a derivative thereof.

Specific examples of the group shown by "-C(R¹⁹)₃" in the general formula (8) include groups shown by the following general formulas (9a) to (9e), and a group shown by the following formula (9f).

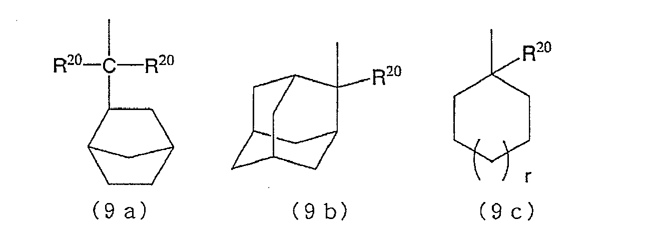

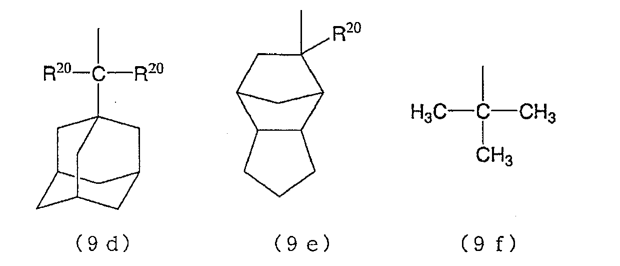

wherein R²⁰ individually represent a linear or branched alkyl group having 1 to 4 carbon atoms, and r is 0 or 1.

The group shown by "-COOC(R¹⁹)₃" in the general formula (9) dissociates due to an acid to form a carboxyl group, and serves as an alkali-soluble moiety. The term "alkali-soluble moiety" refers to a group that becomes an anion due to alkali (i.e., alkali-soluble group). The term "acid-dissociable group" refers to a group in which the alkali-soluble moiety is protected by a protecting group, and which is not alkali-soluble until the protecting group dissociates due to an acid.

The acid-dissociable group-containing resin is insoluble or scarcely soluble in alkali, but becomes alkali-soluble due to an acid. The expression "insoluble or scarcely soluble in alkali" means that a film formed only of a resin that includes a repeating unit shown by the general formula (9) has a thickness equal to or more than 50% of the initial thickness when developed under development conditions employed when forming a resist pattern using a resist layer formed of a resist material including a resin that includes a repeating unit shown by the general formula (9). The expression "alkali-soluble" means that 50% or more of the initial thickness of the film is lost (dissolved) when developed under the above development conditions.

### (Production of acid-dissociable group-containing resin)

The acid-dissociable group-containing resin may be produced by polymerizing a monomer component that includes polymerizable unsaturated monomers corresponding to the desired repeating units in an appropriate solvent optionally in the presence of a chain transfer agent using a radical initiator (e.g., hydroperoxide, dialkyl peroxide, diacyl peroxide, or azo compound).

Examples of the solvent used for polymerization include alkanes such as n-pentane, n-hexane, n-heptane, n-octane, n-nonane, and n-decane; cycloalkanes such as cyclohexane, cycloheptane, cyclooctane, decalin, and norbornane; aromatic hydrocarbons such as benzene, toluene, xylene, ethylbenzene, and cumene; halogenated hydrocarbons such as chlorobutanes, bromohexanes, dichloroethanes, hexamethylene dibromide, and chlorobenzene; saturated carboxylic acid esters such as ethyl acetate, n-butyl acetate, i-butyl acetate, and methyl propionate; ethers such as tetrahydrofuran, dimethoxyethanes, and diethoxyethanes; alcohols such as methanol, ethanol, 1-propanol, 2-propanol, 1-butanol, 2-butanol, isobutanol, 1-pentanol, 3-pentanol, 4-methyl-2-pentanol, o-chlorophenol, and 2-(1-methylpropyl)phenol; ketones such as acetone, 2-butanone, 3-methyl-2-butanone, 4-methyl-2-pentanone, 2-heptanone, cyclopentanone, cyclohexanone, and methylcyclohexanone; and the like. These solvents may be used either individually or in combination.

The reaction temperature is normally 40 to 150°C, and preferably 50 to 120°C. The reaction (polymerization) time is normally 1 to 48 hours, and preferably 1 to 24 hours.

### (Properties of acid-dissociable group-containing resin)

The Mw of the acid-dissociable group-containing resin is normally 1000 to 500,000, preferably 1000 to 100,000, and still more preferably 1000 to 50,000. If the Mw of the acid-dissociable group-containing resin is less than 1000, the heat resistance of the resulting resist pattern may decrease. If the Mw of the acid-dissociable group-containing resin exceeds 500,000, the developability may decrease.

The ratio (Mw/Mn) of the Mw to the polystyrene-reduced number average molecular weight (Mn) of the acid-dissociable group-containing resin determined by gel permeation chromatography (GPC) is preferably 1 to 5, and more preferably 1 to 3.

It is preferable that the acid-dissociable group-containing resin have an impurity (e.g., halogen or metal) content as low as possible in order to improve the sensitivity, resolution, process stability, pattern profile, and the like. The acid-dissociable group-containing resin may be purified by chemical purification (e.g., washing with water or liquid-liquid extraction), or a combination of chemical purification and physical purification (e.g., ultrafiltration or centrifugation), for example. The content (solid content) of low-molecular-weight components containing a monomer as the main component is preferably 0.1 mass% or less based on the total amount of the acid-dissociable group-containing resin. The content of low-molecular-weight components may be determined by high-performance liquid chromatography (HPLC), for example.

### 2. Acid generator

The acid generator included in the resist material generates an acid upon exposure so that the acid-dissociable group dissociates. Therefore, the exposed area of the resist layer becomes alkali-soluble to form a resist pattern.

The content of the acid generator in the resist material is normally 0.1 to 20 parts by mass, and preferably 0.5 to 10 parts by mass, based on 100 parts by mass of the acid-dissociable group-containing resin, so that the resist material exhibits excellent sensitivity and developability. If the content of the acid generator is less than 0.1 parts by mass, the sensitivity and the developability of the resist material may decrease. If the content of the acid generator exceeds 20 parts by mass, it may be difficult to form a rectangular resist pattern due to a decrease in transparency to radiation.

The acid generator preferably includes an acid generator having a structure shown by the following general formula (10). The acid generator may also include an acid generator (hereinafter referred to as "additional acid generator") other than the acid generator having a structure shown by the general formula (10).

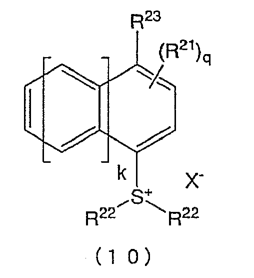

wherein R²¹ represents a linear or branched alkyl group having 1 to 10 carbon atoms, an alkoxy group, or a linear, branched, or cyclic alkanesulfonyl group having 1 to 10 carbon atoms, R²² individually represent a linear or branched alkyl group having 1 to 10 carbon atoms, a substituted or unsubstituted phenyl group, or a substituted or unsubstituted naphthyl group, or bond to form a substituted or unsubstituted divalent group having 2 to 10 carbon atoms that includes the sulfur cation, R²³ represents a hydrogen atom, a fluorine atom, a hydroxyl group, a linear or branched alkyl group having 1 to 10 carbon atoms, a linear or branched alkoxy group having 1 to 10 carbon atoms, or a linear or branched alkoxycarbonyl group having 2 to 11 carbon atoms, k is an integer from 0 to 2, X- represents an anion shown by the general formula (11): R²⁴CₙF₂ₙSO₃⁻ (wherein R²⁴ represents a fluorine atom or a substituted or unsubstituted hydrocarbon group having 1 to 12 carbon atoms, and n is an integer from 1 to 10), and q is an integer from 0 to 10 (preferably an integer from 0 to 2).

The linear or branched alkyl group having 1 to 10 carbon atoms represented by R²¹ to R²³ in the general formula (10) is preferably a methyl group, an ethyl group, an n-butyl group, a t-butyl group, or the like.

The linear or branched alkoxy group having 1 to 10 carbon atoms represented by R²¹ and R²² in the general formula (10) is preferably a methoxy group, an ethoxy group, an n-propoxy group, an n-butoxy group, or the like.

The linear or branched alkoxycarbonyl group having 2 to 11 carbon atoms represented by R²³ in the general formula (10) is preferably a methoxycarbonyl group, an ethoxycarbonyl group, an n-butoxycarbonyl group, or the like.

The linear, branched, or cyclic alkanesulfonyl group having 1 to 10 carbon atoms represented by R²¹ in the general formula (10) is preferably a methanesylfonyl group, an ethanesulfonyl group, an n-propanesulfonyl group, an n-butanesulfonyl group, a cyclopentansulfonyl group, a cyclohexanesulfonyl group, or the like.

The substituted phenyl group represented by R²² in the general formula (10) is preferably a phenyl group, a 4-cyclohexylphenyl group, a 4-t-butylphenyl group, a 4-methoxyphenyl group, a 4-t-butoxyphenyl group, or the like.

The substituted naphthyl group represented by R²² in the general formula (10) is preferably a 1-naphthyl group, a 1-(4-methoxynaphthyl) group, a 1-(4-ethoxynaphthyl) group, a 1-(4-n-propoxynaphthyl) group, a 1-(4-n-butoxynaphthyl) group, a 2-(7-methoxynaphthyl) group, a 2-(7-ethoxynaphthyl) group, a 2-(7-n-propoxynaphthyl) group, a 2-(7-n-butoxynaphthyl) group, or the like.

The sulfur cation-containing divalent group having 2 to 10 carbon atoms formed by the two R²² in the general formula (10) is preferably a group that forms a five- or six-membered ring (preferably a five-membered ring (i.e., tetrahydrothiophene ring)) together with the sulfur cation in the general formula (10). Examples of a substituent for the divalent group include the groups (e.g., hydroxyl group, carboxyl group, cyano group, nitro group, alkoxy group, alkoxyalkyl group, alkoxycarbonyl group, and alkoxycarbonyloxy group) mentioned above in connection with a phenyl group and the alkyl-substituted phenyl group.

Specific examples of the cation moiety in the general formula (10) include a triphenylsulfonium cation, a tri-1-naphthylsulfonium cation, a tri-tert-butylphenylsulfonium cation, a 4-fluorophenyl-diphenylsulfonium cation, a di-4-fluorophenyl-phenylsulfonium cation, a tri-4-fluorophenylsulfonium cation, a 4-cyclohexylphenyl-diphenylsulfonium cation, a 4-methanesulfonylphenyl-diphenylsulfonium cation, a 4-cyclohexanesulfonyl-diphenylsulfonium cation, a 1-naphthyldimethylsulfonium cation, a 1-naphthyldiethylsulfonium cation, a 1-(4-hydroxynaphthyl)dimethylsulfonium cation, a 1-(4-methylnaphthyl)dimethylsulfonium cation, a 1-(4-methylnaphthyl)diethylsulfonium cation, a 1-(4-cyanonaphthyl)dimethylsulfonium cation, a 1-(4-cyanonaphthyl)diethylsulfonium cation, a 1-(3,5-dimethyl-4-hydroxyphenyl)tetrahydrothiophenium cation, a 1-(4-methoxynaphthyl)tetrahydrothiophenium cation, a 1-(4-ethoxynaphthyl)tetrahydrothiophenium cation, a 1-(4-n-propoxynaphthyl)tetrahydrothiophenium cation, a 1-(4-n-butoxynaphthyl)tetrahydrothiophenium cation, a 2-(7-methoxynaphthyl)tetrahydrothiophenium cation, a 2-(7-ethoxynaphthyl)tetrahydrothiophenium cation, a 2-(7-n-propoxynaphthyl)tetrahydrothiophenium cation, a 2-(7-n-butoxynaphthyl)tetrahydrothiophenium cation, and the like.

The group "CₙF₂ₙ-" in the anion (general formula (11)) represented by X- in the general formula (10) is a perfluoroalkylene group having n carbon atoms. The perfluoroalkylene group may be linear or branched.
n is preferably 1, 2, 4, or 8. The substituted or unsubstituted hydrocarbon group having 1 to 12 carbon atoms represented by R²⁴ is preferably an alkyl group having 1 to 12 carbon atoms, a cycloalkyl group, or a bridged alicyclic hydrocarbon group. Specific examples of the substituted or unsubstituted hydrocarbon group having 1 to 12 carbon atoms include a methyl group, an ethyl group, an n-propyl group, an i-propyl group, an n-butyl group, a 2-methylpropyl group, a 1-methylpropyl group, a t-butyl group, an n-pentyl group, an neopentyl group, an n-hexyl group, a cyclohexyl group, an n-heptyl group, an n-octyl group, a 2-ethylhexyl group, an n-nonyl group, an n-decyl group, a norbornyl group, a norbornylmethyl group, a hydroxynorbornyl group, an adamantyl group, and the like.

Examples of a preferable anion moiety in the general formula (10) include a trifluoromethanesulfonate anion, a perfluoro-n-butanesulfonate anion, a perfluoro-n-octanesulfonate anion, a 2-bicyclo[2.2.1]hept-2-yl-1,1,2,2-tetrafluoroethanesulfonate anion, a 2-bicyclo[2.2.1]hept-2-yl-1,1-difluoroethanesulfonate anion, and the like.

The acid generators having a structure shown by the general formula (10) may be used either individually or in combination.

### (Additional acid generator)

Examples of the additional acid generator include onium salt compounds, halogen-containing compounds, diazoketone compounds, sulfone compounds, sulfonic acid compounds, and the like. These additional acid generators may be used either individually or in combination.

The content of the additional acid generator is normally 80 mass% or less, and preferably 60 mass% or less, based on the total amount (=100 mass%) of the acid generator.

### 3. Solvent

The resist material is preferably a solution prepared by dissolving the acid-dissociable group-containing resin, the acid generator, and the like in a solvent. In this case, a uniform film can be formed.

The solvent is normally used in such an amount that the resist material has a solid content of 2 to 70 mass%, preferably 4 to 25 mass%, and more preferably 4 to 10 mass%.

The solvent is preferably at least one solvent selected from the group consisting of propylene glycol monomethyl ether acetate, 2-heptanone, and cyclohexanone (hereinafter referred to as "solvent (1)"). A solvent (hereinafter referred to as "additional solvent") other than the solvent (1) may also be used. It is also possible to use the solvent (1) and the additional solvent in combination.

### (Additional solvent)

Examples of the additional solvent include propylene glycol monoalkyl ether acetates such as propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, and 2-octanone;

cyclic ketones such as cyclopentanone, 3-methylcyclopentanone, 2-methylcyclohexanone, 2,6-dimethylcyclohexanone, and isophorone; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate;

n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, ethyl 2-hydroxy-2-methyl propionate, ethoxyethyl acetate, ethyl hydroxyacetate, methyl 2-hydroxy-3-methylbutyrate, 3-methoxybutylacetate, 3-methyl-3-methoxybutylacetate, 3-methyl-3-methoxybutylpropionate, 3-methyl-3-methoxybutylbutyrate, ethyl acetate, n-propyl acetate, n-butyl acetate, methyl acetoacetate, ethyl acetoacetate, methyl pyruvate, ethyl pyruvate, N-methyl pyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, gamma-butyrolactone, ethylene carbonate, propylene carbonate, and the like.

Among these, linear or branched ketones, cyclic ketones, propylene glycol monoalkyl ether acetates, alkyl 2-hydroxypropionates, alkyl 3-alkoxypropionates, gamma-butyrolactone, and the like are preferable. These additional solvents may be used either individually or in combination.

When using the solvent (1) and the additional solvent in combination, the additional solvent is normally used in an amount of 50 mass% or less, preferably 30 mass% or less, and still more preferably 25 mass% or less, based on the total amount (=mass%) of the solvents.

### 4. Acid diffusion controller

It is preferable that the resist material include an acid diffusion controller. The acid diffusion controller controls diffusion of an acid generated from the acid generator upon exposure within the resist layer, and suppresses undesired chemical reactions in the unexposed area. The acid diffusion controller improves the storage stability of the resist material and the resolution of the resist. Moreover, a change in line width of the resist pattern due to a change in post-exposure delay (PED) can be prevented, so that a resist material with excellent process stability can be obtained.

The acid diffusion controller is normally used in an amount of 15 parts by mass or less, preferably 10 parts by mass or less, and still more preferably 5 parts by mass or less, based on 100 parts by mass of the acid-dissociable group-containing resin. If the amount of the acid diffusion controller is more than 15 parts by mass, the sensitivity of the resist material may decrease. If the amount of the acid diffusion controller is less than 0.001 parts by mass, the shape or the dimensional accuracy of the resist pattern may deteriorate depending on the process conditions.

A nitrogen-containing organic compound or a photodegradable base is preferably used as the acid diffusion controller. The acid diffusion controllers may be used either individually or in combination.

### (Nitrogen-containing organic compound)

Examples of the nitrogen-containing organic compound include a compound shown by the following general formula (12) (hereinafter referred to as "nitrogen-containing compound (1)"), a compound that includes two nitrogen atoms in the molecule (hereinafter referred to as "nitrogen-containing compound (2)"), a polyamino compound that includes three or more nitrogen atoms in the molecule and a polymer thereof (hereinafter collectively referred to as "nitrogen-containing compound (3)"), amide group-containing compounds, urea compounds, nitrogen-containing heterocyclic compounds, and the like.

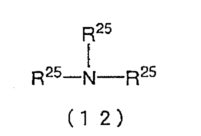

wherein R²⁵ individually represent a hydrogen atom, a substituted or unsubstituted linear, branched, or cyclic alkyl group, a substituted or unsubstituted aryl group, or a substituted or unsubstituted aralkyl group.

### (Photodegradable base)

The term "photodegradable base" used herein refers an onium salt compound that loses acid diffusion controllability upon decomposition due to exposure. Specific examples of the photodegradable base include a sulfonium salt compound shown by the following general formula (13) and an iodonium salt compound shown by the following general formula (14).

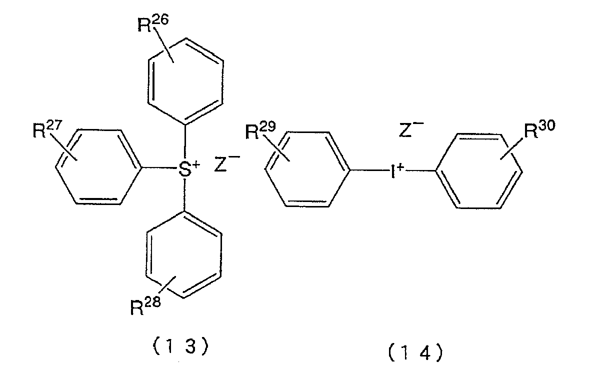

wherein R²⁶ to R³⁰ individually represent a hydrogen atom, an alkyl group, an alkoxy group, a hydroxyl group, or a halogen atom, and Z- represents OH-, R³¹-COO⁻, R³¹-SO₃⁻ (wherein R³¹ represents an alkyl group, an aryl group, or an alkaryl group), or an anion shown by the following general formula (15).

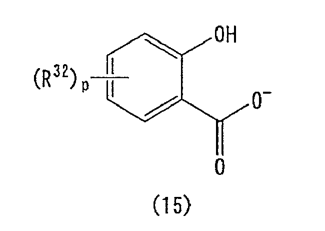

wherein R³² represents a linear or branched alkyl group having 1 to 12 carbon atoms that may be substituted with a fluorine atom, or a linear or branched alkoxy group having 1 to 12 carbon atoms, and p is 1 or 2.

### 5. Additives

The resist material may optionally include additives such as a surfactant, a sensitizer, and an aliphatic additive.

### (Surfactant)

The surfactant improves the applicability, striation, developability, and the like. Examples of the surfactant include nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, and polyethylene glycol distearate; commercially available products such as KP341 (manufactured by Shin-Etsu Chemical Co., Ltd.), Polyflow No. 75, Polyflow No. 95 (manufactured by Kyoeisha Chemical Co., Ltd.), EFTOP EF301, EFTOP EF303, EFTOP EF352 (manufactured by JEMCO, Inc.), Megafac F171, Megafac F173 (manufactured by DIC Corporation), Fluorad FC430, Fluorad FC431 (manufactured by Sumitomo 3M Ltd.), Asahi Guard AG710, Surflon S-382, Surflon SC-101, Surflon SC-102, Surflon SC-103, Surflon SC-104, Surflon SC-105, Surflon SC-106 (manufactured by Asahi Glass Co., Ltd.); and the like. These surfactants may be used either individually or in combination. The surfactant is normally used in an amount of 2 parts by mass or less based on 100 parts by mass of the acid-dissociable group-containing resin.

### (Sensitizer)

The sensitizer absorbs the energy of radiation, and transmits the absorbed energy to the acid generator so that the amount of acid generated by the acid generator increases. The sensitizer improves the apparent sensitivity of the resist material. Examples of the sensitizer include carbazoles, acetophenones, benzophenones, naphthalenes, phenols, biacetyl, eosine, rose bengal, pyrenes, anthracenes, phenothiazines, and the like. These sensitizers may be used either individually or in combination. The sensitizer is normally used in an amount of 50 parts by mass or less based on 100 parts by mass of the acid-dissociable group-containing resin.

### (Alicyclic additive)

The alicyclic additive further improves the dry etching resistance, the pattern shape, adhesion to a substrate, and the like. Examples of the alicyclic additive include alicyclic additives including an acid-dissociable group, alicyclic additives that do not include an acid-dissociable group, and the like. Specific examples of the alicyclic additive include adamantane derivatives such as 1-adamantanecarboxylic acid, 2-adamantanone, t-butyl-1-adamantanecarboxylate, t-butoxycarbonylmethyl 1-adamantanecarboxylate, α-butyrolactone 1-adamantanecarboxylate, di-t-butyl 1,3-adamantanedicarboxylate, t-butyl 1-adamantaneacetate, t-butoxycarbonylmethyl 1-adamantaneacetate, di-t-butyl 1,3-adamantanediacetate, and 2,5-dimethyl-2,5-di(adamantylcarbonyloxy)hexane; deoxycholates such as t-butyl deoxycholate, t-butoxycarbonylmethyl deoxycholate, 2-ethoxyethyl deoxycholate, 2-cyclohexyloxyethyl deoxycholate, 3-oxocyclohexyl deoxycholate, tetrahydropyranyl deoxycholate, and mevalonolactone deoxycholate; lithocholates such as t-butyl lithocholate, t-butoxycarbonylmethyl lithocholate, 2-ethoxyethyl lithocholate, 2-cyclohexyloxyethyl lithocholate, 3-oxocyclohexyl lithocholate, tetrahydropyranyl lithocholate, and mevalonolactone lithocholate; 3-(2-hydroxy-2,2-bis(trifluoromethyl)ethyl)tetracyclo[6.2.1.1^{3,6}.0^{2.7}]dodecane; and the like.

These alicyclic additives may be used either individually or in combination. The alicyclic additive is normally used in an amount of 50 parts by mass or less, and preferably 30 parts by mass or less, based on 100 parts by mass of the acid-dissociable group-containing resin. If the amount of the alicyclic additive is more than 50 parts by mass, the heat resistance of the resulting resist may decrease. Examples of other additives include a dye or a pigment that visualizes a latent image in the exposed area to reduce the effects of halation during exposure, an adhesion improver that improves adhesion to a substrate, an alkali-soluble resin, a low-molecular-weight alkali solubility controller that includes an acid-dissociable protecting group, a halation inhibitor, a preservative, an antifoaming agent, and the like.

The resist material may be prepared by dissolving each component in the solvent, and filtering the solution through a filter having a pore size of about 0.2 µm, for example. The resist material thus prepared may be applied to a substrate.

### EXAMPLES

The invention is further described below by way of examples. Note that the invention is not limited to the following examples. In the examples and comparative examples, the unit "parts" refers to "parts by mass", and the unit "%" refers to "mass%", unless otherwise indicated. The property measuring methods and the property evaluation methods employed in the examples and comparative examples are described below.

Weight average molecular weight (Mw) and number average molecular weight (Mn): The weight average molecular weight (Mw) and the number average molecular weight (Mn) were measured by gel permeation chromatography (GPC) using GPC columns manufactured by Tosoh Corp. (G2000HXL×2, G3000HXL×1, G4000HXL×1) (flow rate: 1.0 ml/min, eluant: tetrahydrofuran, column temperature: 40°C, standard: monodisperse polystyrene). The dispersity (Mw/Mn) was calculated from the Mw and Mn measurement results.

Low-molecular-weight component residual rate (%): The low-molecular-weight component residual rate was determined by high-performance liquid chromatography (HPLC) using an Intersil ODS-25 µm column (4.6 mm (diameter) × 250 mm) (manufactured by GL Sciences Inc.) (flow rate: 1.0 ml/min, eluant: acrylonitrile/0.1% phosphoric acid aqueous solution). The term "low-molecular-weight component" refers to a component (mainly a monomer) having a molecular weight of less than 1000 (preferably components having a molecular weight equal to or lower than that of trimers).

¹³C-NMR analysis: Each polymer was subjected to ¹³C-NMR analysis (solvent: CDCL₃) using an instrument "JNM-EX270" (manufactured by JEOL Ltd.).

Evaluation of pattern: The pattern was evaluated using a scanning electron microscope ("S-9380" manufactured by Hitachi High-Technologies Corporation). When evaluating the insolubilized resist pattern formed on the evaluation substrate B, a case where the first resist pattern remained was evaluated as "Good", and a case where the first resist pattern was lost was evaluated as "Bad". When evaluating the second resist pattern formed on the evaluation substrate C, a case where a 50 nm line/200 nm pitch pattern could be formed within the space area of the insolubilized resist pattern formed on the evaluation substrate B was evaluated as "Good", and a case where (i) the insolubilized resist pattern was lost, (ii) the second resist pattern was not formed, or (iii) the second resist pattern was formed, but remained undissolved on the insolubilized resist pattern was evaluated as "Bad".

Evaluation of top loss: A case where the height of the insolubilized resist pattern was 105 nm or more when forming the evaluation substrate C was evaluated as "Good", and a case where the height of the insolubilized resist pattern was less than 105 nm when forming the evaluation substrate C was evaluated as "Bad".

Evaluation of LWR: A case where the LWR (i.e., a variation (3σ) in line width (measured at 32 points)) of the insolubilized resist pattern was less than 5 nm when forming the evaluation substrate C was evaluated as "Good", and a case where the LWR of the insolubilized resist pattern was 5 nm or more when forming the evaluation substrate C was evaluated as "Bad".

Sensitivity (mJ/cm²): A dose at which a line/pitch resist pattern having the desired line width was formed was taken as the sensitivity. A scanning electron microscope ("S-9380" manufactured by Hitachi High-Technologies Corporation) was used for the measurement.

### (Synthesis Example 1: Polymer (A-1))

53.93 g (50 mol%) of the compound shown by the following formula (L-1), 10.69 g (10 mol%) of the compound shown by the following formula (L-2), and 35.38 g (40 mol%) of the compound shown by the following formula (L-3) were dissolved in 200 g of 2-butanone. 5.58 g of azobisisobutyronitrile (AIBN) was added to the solution to prepare a monomer solution. A three-necked flask (1000 ml) was charged with 100 g of 2-butanone, purged with nitrogen for 30 minutes, and heated to 80°C with stirring. The monomer solution prepared as described above was added dropwise to the flask using a dropping funnel over three hours. The monomers were polymerized for six hours from the start of the addition of the monomer solution. After completion of polymerization, the polymer solution was cooled with water to 30°C or less, and added to 2000 g of methanol. A white powdery precipitate was collected by filtration. The white powder thus collected was washed twice with 400 g of methanol in a slurry state, collected by filtration, and dried at 50°C for 17 hours to obtain a white powdery polymer (A-1) (74 g, yield: 74%). The polymer (A-1) had an Mw of 6900, a dispersity (Mw/Mn) of 1.70, and a low-molecular-weight component residual rate of 0.03%. As a result of ¹³C-NMR analysis, the polymer (A-1) was found to contain the repeating units shown by the following formula (A-1). The content (molar ratio) of the repeating units was a/b/c=53.0/9.8/37.2. The polymer (A-1) is referred to as an acid-dissociable group-containing resin (A-1).

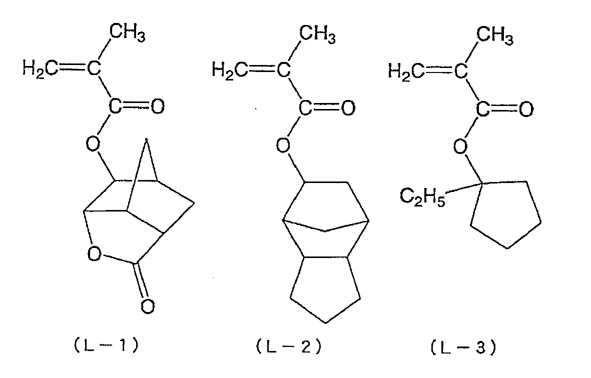

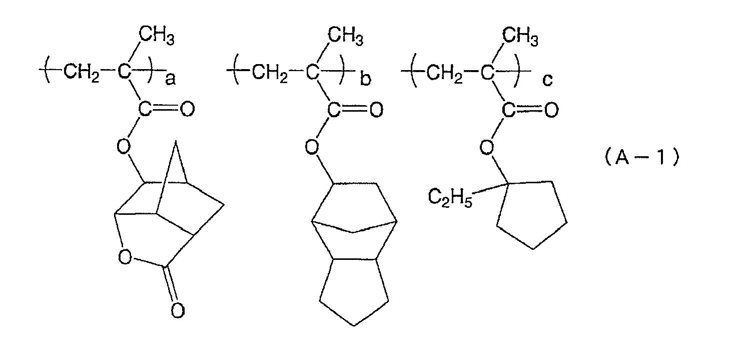

### (Synthesis Example 2: Polymer (A-2))

A polymer (A-2) was obtained in the same manner as in Synthesis Example 1, except for using 39.14 g (37 mol%) of the compound shown by the following formula (L-4) instead of the compound shown by the formula (L-2), and using 50.16 g (50 mol%) of the compound shown by the formula (L-1) and 10.70 g (13 mol%) of the compound shown by the formula (L-3) (78 g, yield: 78%). The polymer (A-2) had an Mw of 5200, a dispersity (Mw/Mn) of 1.62, and a low-molecular-weight component residual rate of 0.03%. As a result of ¹³C-NMR analysis, the polymer (A-2) was found to contain the repeating units shown by the following formula (A-2). The content (molar ratio) of the repeating units was a/b/c=50.0/37.0/13.0. The polymer (A-2) is referred to as an acid-dissociable group-containing resin (A-2).

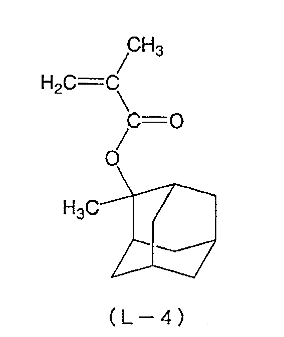

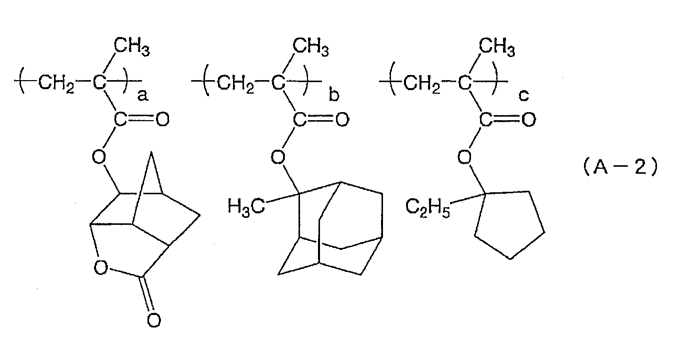

### (Synthesis Example 3: Polymer (A-3))

A polymer (A-3) was obtained in the same manner as in Synthesis Example 1, except for using 9.72 g (10 mol%) of the compound shown by the following formula (L-5) instead of the compound shown by the formula (L-2), and using 54.51 g (50 mol%) of the compound shown by the formula (L-1) and 35.76 g (40 mol%) of the compound shown by the formula (L-3) (71 g, yield: 71%). The polymer (A-3) had an Mw of 8100, a dispersity (Mw/Mn) of 1.69, and a low-molecular-weight component residual rate of 0.04%. As a result of ¹³C-NMR analysis, the polymer (A-2) was found to contain the repeating units shown by the following formula (A-3). The content (molar ratio) of the repeating units was a/b/c=53.6/9.8/36.6. The polymer (A-3) is referred to as an acid-dissociable group-containing resin (A-3).

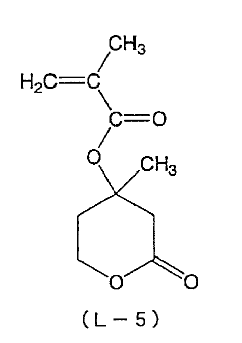

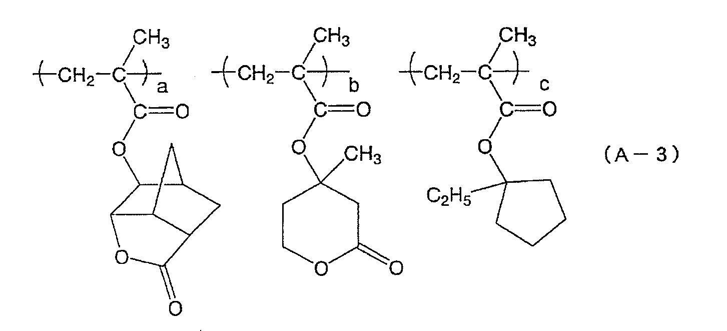

### (Synthesis Example 4: Polymer (A-4))

A polymer (A-4) was obtained in the same manner as in Synthesis Example 1, except for using 24.42 g (15 mol%) of the compound shown by the following formula (L-6) instead of the compound shown by the formula (L-2), using 30.40 g (40 mol%) of the compound shown by the following formula (L-7) instead of the compound shown by the formula (L-3), and using 45.18 g (45 mol%) of the compound shown by the formula (L-1) (75 g, yield: 75%). The polymer (A-4) had an Mw of 6100, a dispersity (Mw/Mn) of 1.73, and a low-molecular-weight component residual rate of 0.04%. As a result of ¹³C-NMR analysis, the polymer (A-4) was found to contain the repeating units shown by the following formula (A-4). The content (molar ratio) of the repeating units was a/b/c=44.1/15.5/40.4. The polymer (A-4) is referred to as an acid-dissociable group-containing resin (A-4).

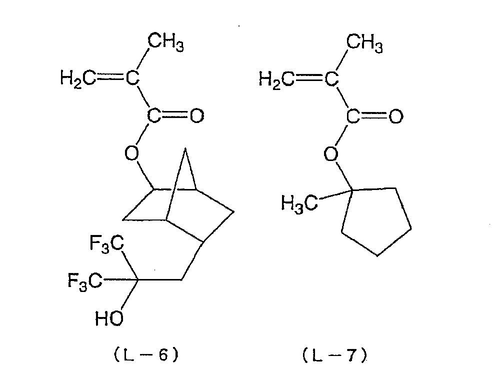

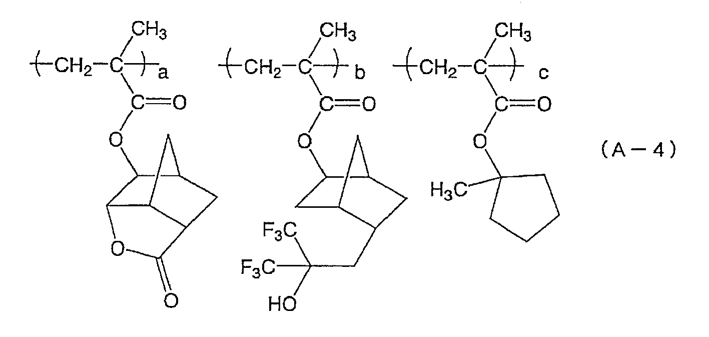

### (Synthesis Example 5: Polymer (A-5))

A polymer (A-5) was obtained in the same manner as in Synthesis Example 1, except for using 35.60 g (35 mol%) of the compound shown by the formula (L-4) instead of the compound shown by the formula (L-2), using 16.17 g (15 mol%) of the compound shown by the following formula (L-8) instead of the compound shown by the formula (L-3), and using 48.23 g (50 mol%) of the compound shown by the formula (L-1) (72 g, yield: 72%). The polymer (A-5) had an Mw of 8200, a dispersity (Mw/Mn) of 1.78, and a low-molecular-weight component residual rate of 0.03%. As a result of ¹³C-NMR analysis, the polymer (A-5) was found to contain the repeating units shown by the following formula (A-5). The content (molar ratio) of the repeating units was a/b/c=50.0/36.9/13.1. The polymer (A-5) is referred to as an acid-dissociable group-containing resin (A-5).

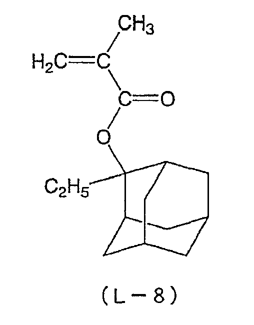

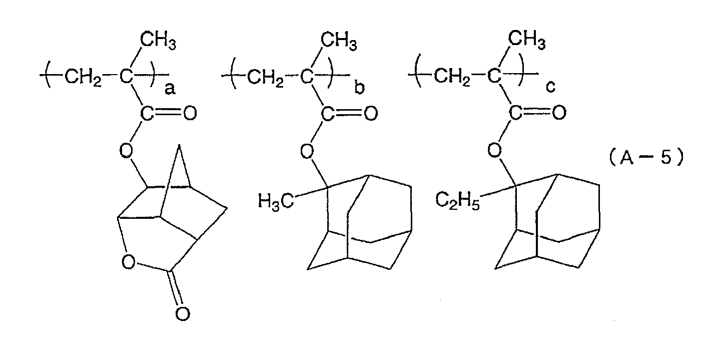

### (Synthesis Example 6: Polymer (A-6))

A polymer (A-6) was obtained in the same manner as in Synthesis Example 1, except for using 28.40 g (35 mol%) of the compound shown by the formula (L-7) instead of the compound shown by the formula (L-2), using 18.00 g (15 mol%) of the compound shown by the formula (L-8) instead of the compound shown by the formula (L-3), and using 53.60 g (50 mol%) of the compound shown by the formula (L-1) (73 g, yield: 73%). The polymer (A-6) had an Mw of 7100, a dispersity (Mw/Mn) of 1.40, and a low-molecular-weight component residual rate of 0.01 %. As a result of ¹³C-NMR analysis, the polymer (A-6) was found to contain the repeating units shown by the following formula (A-6). The content (molar ratio) of the repeating units was a/b/c=50.0/35.2/14.8. The polymer (A-6) is referred to as an acid-dissociable group-containing resin (A-6).

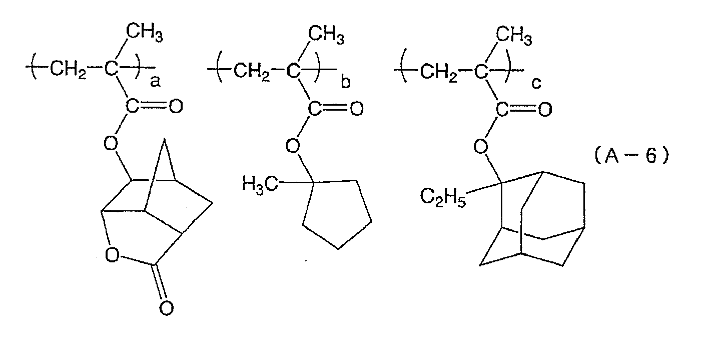

### (Synthesis Example 7: Polymer (A-7))

A polymer (A-7) was obtained in the same manner as in Synthesis Example 1, except for using 52.78 g (50 mol%) of the compound shown by the formula (L-8) instead of the compound shown by the formula (L-2), and using 47.22 g (50 mol%) of the compound shown by the formula (L-1) without using the compound shown by the formula (L-3) (65 g, yield: 65%). The polymer (A-7) had an Mw of 5500, a dispersity (Mw/Mn) of 1.35, and a low-molecular-weight component residual rate of 0.01%. As a result of ¹³C-NMR analysis, the polymer (A-7) was found to contain the repeating units shown by the following formula (A-7). The content (molar ratio) of the repeating units was a/b=55.2/44.8. The polymer (A-7) is referred to as an acid-dissociable group-containing resin (A-7).

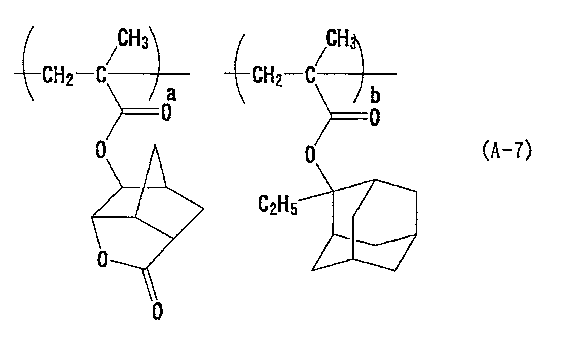

### (Preparation of resist material)

First resist materials (1) to (8) and second resist materials (9) to (15) were prepared using the polymers (A-1) to (A-7) produced in Synthesis Examples 1 to 7, an acid generator, an acid diffusion controller, and a solvent in amounts shown in Table 1.

**TABLE 1**

| Resist material | | Acid-dissociable group-containing resin | | Acid generator | | Acid diffusion controller | | Solvent | |
|---|---|---|---|---|---|---|---|---|---|
| Type | | Type | Amount (parts) | Type | Amount (parts) | Type | Amount (parts) | Type | Amount (parts) |
| First resist material | 1 | A-1 | 100 | D-1 | 6 | E-1 | 0.5 | F-1 | 1420 |
| | | | | D-2 | 1 | | | F-2 | 30 |
| | 2 | A-2 | 100 | D-1 | 6 | E-1 | 0.5 | F-1 | 1420 |
| | | | | D-2 | 1 | | | F-2 | 30 |
| | 3 | A-3 | 100 | D-1 | 6 | E-1 | 0.5 | F-1 | 1420 |
| | | | | D-2 | 1 | | | F-2 | 30 |
| | 4 | A-5 | 100 | D-1 | 6 | E-1 | 0.5 | F-1 | 1420 |
| | | | | D-2 | 1 | | | F-2 | 30 |
| | 5 | A-1 | 100 | D-1 | 6 | E-2 | 3 | F-1 | 1420 |
| | | | | D-2 | 1 | | | F-2 | 30 |
| | 6 | A-2 | 100 | D-1 | 6 | E-1 | 0.5 | F-1 | 1420 |
| | | | | D-3 | 1 | | | F-2 | 30 |
| | 7 | A-6 | 100 | D-4 | 7 | E-1 | 0.5 | F-1 | 1420 |
| | | | | | | | | F-2 | 30 |
| | 8 | A-2 | 100 | D-3 | 7 | E-1 | 0.5 | F-1 | 1420 |
| | | | | D-4 | 2 | | | F-2 | 30 |
| Second resist material | 9 | A-4 | 100 | D-1 | 7 | E-2 | 2 | F-1 | 1420 |
| | | | | | | | | F-2 | 30 |
| | 10 | A-4 | 100 | D-2 | 7 | E-3 | 3 | F-1 | 1420 |
| | | | | | | | | F-2 | 30 |
| | 11 | A-4 | 100 | D-2 | 7 | E-1 | 0.2 | F-1 | 1420 |
| | | | | | | E-2 | 1 | F-2 | 30 |
| | 12 | A-4 | 100 | D-2 | 7 | E-1 | 0.5 | F-1 | 1420 |
| | | | | | | | | F-2 | 30 |
| | 13 | A-6 | 100 | D-4 | 7 | E-1 | 0.5 | F-1 | 1420 |
| | | | | | | | | F-2 | 30 |
| | 14 | A-2 | 100 | D-2 | 7 | E-2 | 3 | F-1 | 1420 |
| | | | | | | | | F-2 | 30 |
| | 15 | A-7 | 100 | D-2 | 7 | E-2 | 3 | F-1 | 1015 |
| | | | | | | | | F-3 | 435 |

The details of the acid generator, the acid diffusion controller, and the solvent shown in Table 1 are given below.

### (Acid generator)

(D-1): 4-nonafluoro-n-butylsulfonyloxyphenyl diphenylsulfonium nonafluoro-n-butanesulfonate
(D-2): triphenylsulfonium nonafluoro-n-butanesulfonate
(D-3): 1-(4-n-butoxynaphthal en-1-yl)tetrahydrothiophenium nonafluoro-n-butanesulfonate
(D-4): triphenylsulfonium 2-bicyclo[2.2.1]heptan-2-yl-1,1-difluoroethanesulfonate

### (Acid diffusion controller)

(E-1): (R)-(+)-1-(t-butoxycarbonyl)-2-pyrrolidinemethanol N-t-butoxycarbonylpyrrolidine
(E-2): triphenylsulfonium salicylate
(E-3): triphenylsulfonium 10-camphorsulfonate

### (Solvent)

(F-1): propylene glycol monoethyl ether acetate
(F-2): gamma-butyrolactone
(F-3): cyclohexanone

### (Synthesis Example 8: Hydroxyl group-containing resin (B-1))

62.13 g of p-hydroxymethacrylanilide (hereinafter referred to as "m-1"), 37.87 g of p-t-butoxystyrene (hereinafter referred to as "(m-2)"), and 10.21 g of AIBN were dissolved in 300 g of isopropyl alcohol (IPA). The monomers were polymerized for 6 hours under reflux conditions (82°C). After cooling the reaction vessel with running water, 200 g of ethyl acetate, 140 g of IPA, and 140 g of methanol were added to the polymer solution to obtain a homogenous solution. After the addition of 600 g of water, the mixture was allowed to stand for 1 hour. A viscous polymer that had precipitated in the lower layer was collected, and dried at 50°C under vacuum to obtain a copolymer (B-1) (yield: 70%). The copolymer (B-1) had an Mw of 8500 and a dispersity (Mw/Mn) of 2.08. As a result of ¹³C-NMR analysis, the content (molar ratio) of the repeating units in the copolymer (B-1) was (m-1)/(m-2)=55.4/44.6. The copolymer (B-1) is referred to as a hydroxyl group-containing resin (B-1).

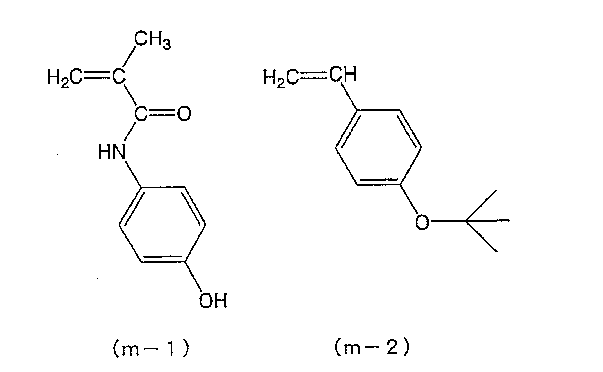

### (Synthesis Example 9: Hydroxyl group-containing resin (B-2))

17.62 g of (m-1), 10.22 g of (m-2), 2.16 g of 2-(((trifluoromethyl)sulfonyl)amino)ethyl-1-methacrylate (hereinafter referred to as "(m-3)"), and 2.18 g of AIBN were dissolved in 90 g of IPA. The monomers were polymerized for 6 hours under reflux conditions (82°C). After cooling the reaction vessel with running water, 60 g of ethyl acetate, 42 g of IPA, and 42 g of methanol were added to the polymer solution to obtain a homogenous solution. After the addition of 180 g of water, the mixture was allowed to stand for 1 hour. A viscous polymer that had precipitated in the lower layer was collected, and dried at 50°C under vacuum to obtain a copolymer (B-2) (yield: 77%). The copolymer (B-2) had an Mw of 5800 and a dispersity (Mw/Mn) of 1.50. As a result of ¹³C-NMR analysis, the content (molar ratio) of the repeating units in the copolymer (B-2) was (m-1)/(m-2)/(m-3)=54.2/41.3/4.5. The copolymer (B-2) is referred to as a hydroxyl group-containing resin (B-2).

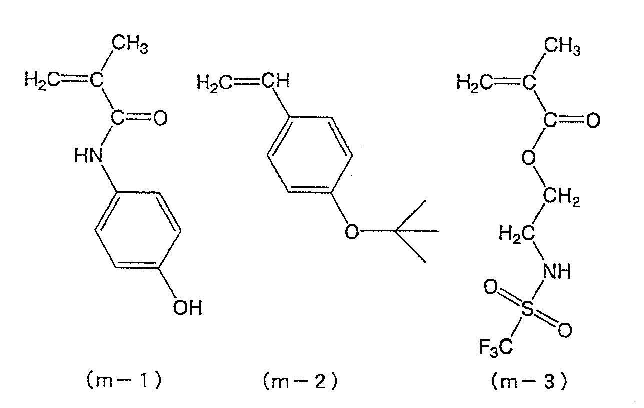

### (Synthesis Example 10: Hydroxyl group-containing resin (B-3))

17.8 g of (m-1), 10.3 g of (m-2), 2.1 g of the monomer shown by the following formula (m-4) (hereinafter referred to as "(m-4)"), and 2.18 g of AIBN were dissolved in 90 g of IPA. The monomers were polymerized for 6 hours under reflux conditions (82°C). After cooling the reaction vessel with running water, 60 g of ethyl acetate, 42 g of IPA, and 42 g of methanol were added to the polymer solution to obtain a homogenous solution. After the addition of 180 g of water, the mixture was allowed to stand for 1 hour. A viscous polymer that had precipitated in the lower layer was collected, and dried at 50°C under vacuum to obtain a copolymer (B-3) (yield: 65%). The copolymer (B-3) had an Mw of 7600 and a dispersity (Mw/Mn) of 1.53. As a result of ¹³C-NMR analysis, the content (molar ratio) of the repeating units in the copolymer (B-3) was (m-1)/(m-2)/(m-4)=60.2/35.0/4.8. The copolymer (B-3) is referred to as a hydroxyl group-containing resin (B-3).

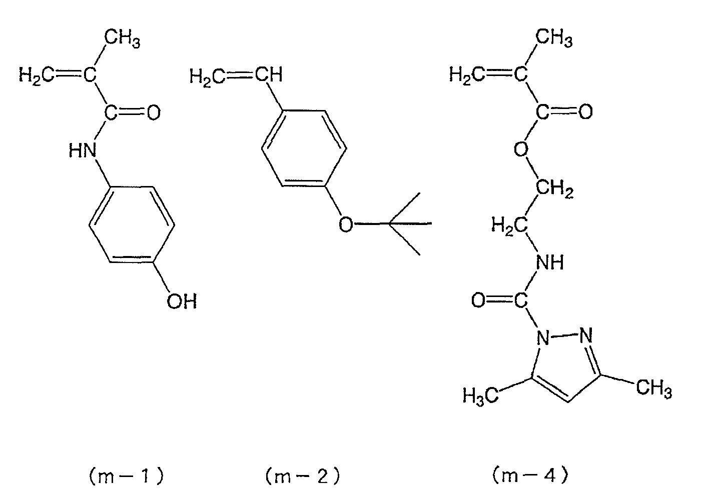

### (Synthesis Example 11: Hydroxyl group-containing resin (B-4))

30.66 g of (m-1), 15.25 g of (m-2), 4.10 g of the monomer shown by the following formula (m-5) (hereinafter referred to as "(m-5)"), and 3.70 g of AIBN were dissolved in 150 g of IPA. The monomers were polymerized for 6 hours under reflux conditions (82°C). After cooling the reaction vessel with running water, 100 g of ethyl acetate, 70 g of IPA, and 70 g of methanol were added to the polymer solution to obtain a homogenous solution. After the addition of 300 g of water, the mixture was allowed to stand for 1 hour. A viscous polymer that had precipitated in the lower layer was collected, and dried at 50°C under vacuum to obtain a polymer (B-4) (yield: 68%). The polymer (B-4) had an Mw of 8200 and a dispersity (Mw/Mn) of 1.50. As a result of ¹³C-NMR analysis, the content (molar ratio) of the repeating units in the polymer (B-4) was (m-1)/(m-2)/(m-5)=55.2/35.5/9.3. The copolymer (B-4) is referred to as a hydroxyl group-containing resin (B-4).

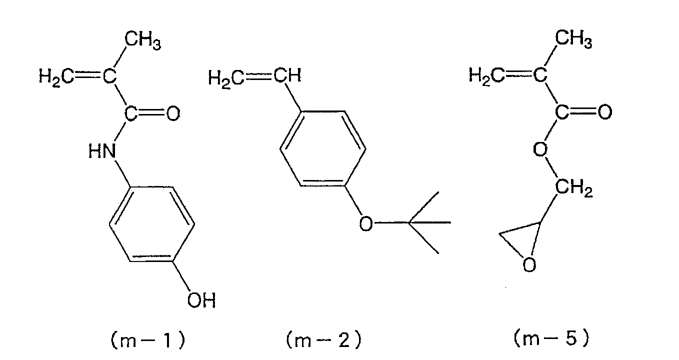

### Example 1

A mixture of 100 parts of the hydroxyl group-containing resin (B-1) produced in Synthesis Example 8, 30 parts ofNikalac MX-750 (manufactured by Nippon Carbide Industries Co., Inc.) (crosslinking component), 1572 parts of 1-butanol (solvent), and 1048 parts of 4-methyl-2-pentanol (solvent) was filtered through a filter having a pore size of 0.03 µm to obtain a coating agent(A).

### Examples 2 to 10 and Comparative Examples 1 and 2

Coating agents (B) to (L) were prepared in the same manner as in Example 1, except for changing the composition as shown in Table 2.

**TABLE2**

| | Resist pattern coating agent | Hydroxyl group-containing resin | | Crosslinking component | | Solvent | |
|---|---|---|---|---|---|---|---|
| | | Type | Amount (parts) | Type | Amount (parts) | Type | Amount (parts) |
| Example 1 | A | B-1 | 100 | C-1 | 30 | F-4 | 1572 |
| | | | | C-1 | 30 | F-5 | 1048 |
| Example 2 | B | B-1 | 100 | C-1 | 30 | F-4 | 524 |
| | | | | | | F-5 | 2096 |
| Example 3 | C | B-1 | 100 | C-1 | 5 | F-4 | 524 |
| | | | | C-3 | 30 | F-5 | 2096 |
| Example 4 | D | B-1 | 100 | C-1 | 5 | F-5 | 2620 |
| | | | | C-3 | 30 | | |
| Example 5 | E | B-2 | 100 | C-1 | 10 | F-4 | 524 |
| | | | | C-3 | 25 | F-5 | 2096 |
| Example 6 | F | B-1 | 100 | C-1 | 5 | F-5 | 2620 |
| | | | | C-2 | 30 | | |
| Example 7 | G | B-3 | 100 | C-1 | 5 | F-4 | 524 |
| | | | | C-4 | 30 | F-5 | 2096 |
| Example 8 | H | B-4 | 100 | C-1 | 5 | F-4 | 524 |
| | | | | C-3 | 30 | F-6 | 2096 |
| Example 9 | I | B-1 | 100 | C-1 | 30 | F-4 | 1572 |
| | | | | | | F-6 | 1048 |
| Example 10 | J | B-1 | 100 | C-1 | 30 | F-4 | 524 |
| | | | | | | F-6 | 2096 |
| Comparative Example 1 | K | B-1 | 100 | C-1 | 30 | F-4 | 2620 |
| Comparative Example 2 | L | B-4 | 100 | C-1 | 30 | F-4 | 2620 |

The details of the crosslinking component and the solvent shown in Table 2 are given below.

### (Crosslinking component)

C-1: Nikalac MX-750 (manufactured by Nippon Carbide Industries Co., Inc.) C-2: pentaerythritol tetracrylate
C-3: OXIPA (manufactured by Ube Industries, Ltd.)
C-4: pentaerythritol triacrylate

### (Solvent)

F-4: 1-butanol
F-5: 4-methyl-2-pentanol
F-6: 3-methyl-1-butanol

Evaluation substrates A and B were produced using the resist material and the coating agent prepared as described above. The types of the first resist material and the coating agent, the heating conditions (PB and PEB), the UV curing conditions, and the pattern evaluation results are shown in Table 3.

### Production of evaluation substrate A

A lower-layer antireflective film composition ("ARC29A" manufactured by Brewer Science) was spin-coated onto a 12-inch silicon wafer using a coater/developer "CLEAN TRACK ACT12" (manufactured by Tokyo Electron Ltd.), and prebaked (PB) (205°C, 60 sec) to form a film (thickness: 77 nm). The first resist material was spin-coated onto the film using the coater/developer "CLEAN TRACK ACT12", prebaked (PB) (115°C, 60 sec), and cooled (23°C, 30 sec) to obtain a coating film (thickness: 150 nm). The coating film was exposed via a mask (50 nm line/200 nm pitch) using an ArF liquid immersion lithography system ("XT1250i" manufactured by ASML) (NA: 0.85, Outer/Inner=0.89/0.59, Annular). The coating film was subjected to PEB (115°C, 60 sec) on the hot plate of the coater/developer "CLEAN TRACK ACT12", cooled (23°C, 30 sec), subjected to paddle development (30 sec) using a 2.38 % tetramethylammonium hydroxide aqueous solution (using the GP nozzle of the development cup), and rinsed with ultrapure water. The wafer was then spin-dried at 2000 rpm for 15 seconds to obtain an evaluation substrate A on which a first resist pattern (48 nm line/200 nm pitch) was formed. The dimensions of the resist pattern were measured using a scanning electron microscope ("S-9380" manufactured by Hitachi High-Technologies Corporation).

### Production of evaluation substrate B

The coating agent was spin-coated onto the first resist pattern formed on the evaluation substrate A to a thickness of 150 nm using the coater/developer "CLEAN TRACK ACT12", and prebaked (PB) (130°C, 60 sec). The film was cooled on a cooling plate (23°C, 30 sec) using the coater/developer "CLEAN TRACK ACT12", subjected to paddle development (60 sec) using a 2.38 % tetramethylammonium hydroxide aqueous solution (using the GP nozzle of the development cup), and rinsed with ultrapure water. The substrate was spin-dried at 2000 rpm for 15 seconds, and prebaked (PB) (165°C, 90 sec) to obtain an evaluation substrate B on which an insolubilized resist pattern was formed.

**TABLE 3**

| Evaluation substrate A | | | | | | Evaluation substrate B | | | | | | |
|---|---|---|---|---|---|---|---|---|---|---|---|---|
| First resist material | PB conditions | | PEB conditions | | Sensitivity (mJ/cm³) | Resist pattern coating agent | Before washing | | After washing | | Type | Evaluation of pattern |
| | Temp. (°C) | Time (sec) | Temp. (°C) | Time (sec) | | | Temp. (°C) | Time (sec) | Temp. (°C) or UV cure | Time (sec) | | |
| 1 | 115 | 60 | 115 | 60 | 28 | C | 130 | 60 | 165 | 90 | 1 | Good |
| 2 | 120 | 60 | 115 | 60 | 28 | C | 130 | 60 | 165 | 90 | 2 | Good |
| 3 | 120 | 60 | 130 | 60 | 27 | C | 130 | 60 | 165 | 90 | 3 | Good |
| 4 | 100 | 60 | 110 | 60 | 28 | C | 130 | 60 | 165 | 90 | 4 | Good |
| 5 | 115 | 60 | 110 | 60 | 27 | C | 130 | 60 | 165 | 90 | 5 | Good |
| 6 | 115 | 60 | 105 | 60 | 27 | C | 130 | 60 | 165 | 90 | 6 | Good |
| 7 | 115 | 60 | 110 | 60 | 27 | C | 130 | 60 | 165 | 90 | 7 | Good |
| 8 | 115 | 60 | 110 | 60 | 28 | C | 130 | 60 | 165 | 90 | 8 | Good |
| 2 | 120 | 60 | 115 | 60 | 27 | A | 130 | 60 | 165 | 90 | 9 | Good |
| 2 | 120 | 60 | 115 | 60 | 28 | B | 130 | 60 | 165 | 90 | 10 | Good |
| 2 | 120 | 60 | 115 | 60 | 28 | D | 130 | 60 | 165 | 90 | 11 | Good |
| 2 | 120 | 60 | 115 | 60 | 28 | E | 130 | 60 | 165 | 90 | 12 | Good |
| 2 | 120 | 60 | 115 | 60 | 28 | F | 130 | 60 | 165 | 90 | 13 | Good |
| 2 | 120 | 60 | 115 | 60 | 28 | G | 130 | 60 | 165 | 90 | 14 | Good |
| 2 | 120 | 60 | 115 | 60 | 27 | H | 130 | 60 | 165 | 90 | 15 | Good |
| 2 | 120 | 60 | 115 | 60 | 27 | I | 130 | 60 | 165 | 90 | 16 | Good |
| 2 | 120 | 60 | 115 | 60 | 28 | J | 130 | 60 | 165 | 90 | 17 | Good |
| 2 | 120 | 60 | 115 | 60 | 27 | K | 130 | 60 | 165 | 90 | 18 | Good |
| 2 | 120 | 60 | 115 | 60 | 28 | L | 130 | 60 | 165 | 90 | 19 | Good |
| 2 | 120 | 60 | 115 | 60 | 27 | C | 130 | 90 | Xe₂ (172 nm) | 60 | 20 | Good |
| 2 | 120 | 60 | 115 | 60 | 28 | C | 130 | 90 | Xe₂(172 nm) | 60 | 21 | Good |

### Examples 11 to 31 and Comparative Examples 3 to 5

The second resist material was applied to the insolubilized resist pattern formed on the evaluation substrate B to produce an evaluation substrate C, and the top loss, the LWR, and the pattern were evaluated. The type of the second resist material, the heating conditions (PB and PEB), and the evaluation results are shown in Table 4.

### Production of evaluation substrate C

The second resist material was spin-coated onto the insolubilized resist pattern formed on the evaluation substrate B using the coater/developer "CLEAN TRACK ACT12", prebaked (PB) (100°C, 60 sec), and cooled (23°C, 30 sec) to obtain a coating film (thickness: 150 nm). The space area of the insolubilized resist pattern was exposed via a mask (50 nm line/200 nm pitch) using the ArF liquid immersion lithography system (NA: 0.85, Outer/Inner=0.89/0.59, Annular). The coating film was subjected to PEB (95°C, 60 sec) on the hot plate of the coater/developer "CLEAN TRACKACT12", cooled (23°C, 30 sec), subjected to paddle development (30 sec) using a 2.38 % tetramethylammonium hydroxide aqueous solution (using the GP nozzle of the development cup), and rinsed with ultrapure water. The substrate was then spin-dried at 2000 rpm for 15 seconds to obtain an evaluation substrate C on which a second resist pattern (50 nm line/100 nm pitch) was formed. The dimensions of the resist pattern were measured using a scanning electron microscope ("S-9380" manufactured by Hitachi High-Technologies Corporation).

**TABLE 4**

| | Evaluation substrate B | Second resist material | Evaluation substrate C | | | | | | | |
|---|---|---|---|---|---|---|---|---|---|---|
| | | | PB conditions | | PEB conditions | | Sensitivity (mJ/cm²) | Evaluation of pattern | Top loss | LWR |
| | | | Temp. (°C) | Time (sec) | Temp. (°C) | Time (sec) | | | | |
| Example 11 | 1 | 11 | 100 | 60 | 95 | 60 | 21 | Good | Good | Good |
| Example 12 | 2 | 11 | 100 | 60 | 95 | 60 | 20 | Good | Good | Good |
| Example 13 | 3 | 9 | 100 | 60 | 95 | 60 | 21 | Good | Good | Good |
| Example 14 | 4 | 9 | 100 | 60 | 95 | 60 | 21 | Good | Good | Good |
| Example 15 | 5 | 11 | 100 | 60 | 95 | 60 | 21 | Good | Good | Good |
| Example 16 | 6 | 9 | 100 | 60 | 95 | 60 | 21 | Good | Good | Good |
| Example 17 | 7 | 11 | 100 | 60 | 95 | 60 | 22 | Good | Good | Good |
| Example 18 | 8 | 11 | 100 | 60 | 95 | 60 | 21 | Good | Good | Good |
| Example 19 | 9 | 10 | 100 | 60 | 95 | 60 | 21 | Good | Good | Good |
| Example 20 | 10 | 12 | 100 | 60 | 95 | 60 | 21 | Good | Good | Good |
| Example 21 | 11 | 11 | 100 | 60 | 95 | 60 | 21 | Good | Good | Good |
| Example 22 | 12 | 9 | 100 | 60 | 95 | 60 | 21 | Good | Good | Good |
| Example 23 | 13 | 11 | 100 | 60 | 95 | 60 | 21 | Good | Good | Good |
| Example 24 | 14 | 11 | 100 | 60 | 95 | 60 | 21 | Good | Good | Good |
| Example 25 | 15 | 11 | 100 | 60 | 95 | 60 | 21 | Good | Good | Good |
| Example 26 | 5 | 13 | 100 | 60 | 95 | 60 | 21 | Good | Good | Good |
| Example 27 | 7 | 14 | 100 | 60 | 95 | 60 | 21 | Good | Good | Good |
| Example 28 | 20 | 11 | 100 | 60 | 95 | 60 | 21 | Good | Good | Good |
| Example 29 | 21 | 11 | 100 | 60 | 95 | 60 | 21 | Good | Good | Good |
| Example 30 | 16 | 11 | 100 | 60 | 95 | 60 | 21 | Good | Good | Good |
| Example 31 | 17 | 11 | 100 | 60 | 95 | 60 | 21 | Good | Good | Good |
| Comparative Example 3 | 18 | 11 | 100 | 60 | 95 | 60 | 21 | Good | Bad | Bad |
| Comparative Example 4 | 19 | 11 | 100 | 60 | 95 | 60 | 21 | Good | Bad | Bad |
| Comparative Example 5 | 19 | 11 | 130 | 60 | 95 | 60 | 21 | Bad | Bad | Bad |

As shown in Table 4, the top loss and the LWR when forming the pattern could be suppressed by utilizing the resist pattern coating agent according to one embodiment of the invention.

### Examples 32 to 34

The second resist material was applied to the insolubilized resist pattern formed on the evaluation substrate B to produce an evaluation substrate D.

### Production of evaluation substrate D

A lower-layer antireflective film composition ("ARC29A" manufactured by Brewer Science) was spin-coated onto a 12-inch silicon wafer using a coater/developer "CLEAN TRACK ACT12" (manufactured by Tokyo Electron Ltd.), and prebaked (PB) (205°C, 60 sec) to form a film (thickness: 77 nm). The first resist material 2 shown in Table 1 was spin-coated onto the film using the coater/developer "CLEAN TRACK ACT12", prebaked (PB) (115°C, 60 sec), and cooled (23°C, 30 sec) to form a coating film (thickness: 150 nm). The coating film was exposed via a mask (22 nm line/88 nm pitch) using an ArF liquid immersion lithography system ("S610C" manufactured by Nikon Corp.) (NA: 1.30, Dipole). The coating film was subjected to PEB (115°C, 60 sec) on the hot plate of a system "Lithius Pro-i", cooled (23°C, 30 sec), subjected to paddle development (10 sec) using a 2.38 % tetramethylammonium hydroxide aqueous solution (using the GP nozzle of the development cup), and rinsed with ultrapure water. The wafer was then spin-dried at 2000 rpm for 15 seconds to obtain an evaluation substrate A' on which a first resist pattern (20 nm line/88 nm pitch) was formed.

The coating agent (C) shown in Ttable 2 was spin-coated onto the first resist pattern formed on the evaluation substrate A' to a thickness of 150 nm using the coater/developer "CLEAN TRACK ACT12", and prebaked (PB) (130°C, 60 sec). The film was cooled on a cooling plate (23°C, 30 sec) using the coater/developer "CLEAN TRACKACT12", subjected to paddle development (60 sec) using a 2.38 % tetramethylammonium hydroxide aqueous solution (using the GP nozzle of the development cup), and rinsed with ultrapure water. The substrate was spin-dried at 2000 rpm for 15 seconds, and prebaked (PB) (165°C, 90 sec) to obtain an evaluation substrate B' on which an insolubilized resist pattern was formed.

The second resist material 9, 10, or 15 was spin-coated onto the evaluation substrate B' using the coater/developer "CLEAN TRACK ACT12", prebaked (PB) (100°C, 60 sec), and cooled (23°C, 30 sec) to obtain a coating film (thickness: 150 nm). The space area of the insolubilized resist pattern was exposed via a mask (22 nm line/88 nm pitch) using an ArF liquid immersion lithography system ("S610C" manufactured by Nikon Corp.) (NA: 1.30, Dipole). The coating film was subjected to PEB (85°C, 60 sec) on the hot plate of the coater/developer "CLEAN TRACK ACT12", cooled (23°C, 30 sec), subjected to paddle development (30 sec) using a 2.38 % tetramethylammonium hydroxide aqueous solution (using the GP nozzle of the development cup), and rinsed with ultrapure water. The substrate was then spin-dried at 2000 rpm for 15 seconds to obtain an evaluation substrate D on which a second resist pattern (22 nm line/44 nm pitch) was formed (Examples 32 to 34; the sensitivity was 21, 20, and 20 mJ/cm², respectively). The dimensions of the resist pattern were measured using a scanning electron microscope ("S-9380" manufactured by Hitachi High-Technologies Corporation).

As is clear from the results for Examples 32 to 34, a 22 nm line/44 nm pitch resist pattern could be formed by utilizing the resist pattern coating agent according to one embodiment of the invention.

### INDUSTRIAL APPLICABILITY

The above resist pattern-forming method can effectively and accurately reduce the space of the resist pattern, and can advantageously and economically form a pattern that exceeds the wavelength limit. Therefore, the above resist pattern-forming method may suitably be used in the field of microfabrication such as production of integrated circuit devices that are expected to be further scaled down in the future.

### EXPLANATION OF SYMBOLS

1: first resist pattern, 2: second resist pattern, 2a, 22a, 32a: second line area, 2b, 22b, 32b: second space area, 3: insolubilized resist pattern, 3 a: first line area, 3b: first space area, 5: insoluble film, 10: substrate, 12: second resist layer, 15: contact hole

## Claims

1. A resist pattern coating agent comprising a hydroxyl group-containing resin, and a solvent that includes an alcohol shown by the following general formula (1): R-OH (wherein R represents a branched alkyl group having 3 to 10 carbon atoms) in an amount of 30 mass% or more, the resist pattern coating agent being used in a step (2) of a resist pattern-forming method that includes (1) forming a first resist pattern on a substrate using a first radiation-sensitive resin composition, (2) treating the first resist pattern with the resist pattern coating agent, and (3) forming a second resist pattern on the substrate treated with the resist pattern coating agent using a second radiation-sensitive resin composition.

2. The resist pattern coating agent according to claim 1, wherein the hydroxyl group-containing resin has been obtained by polymerizing a monomer component that includes a monomer shown by the following general formula (2), 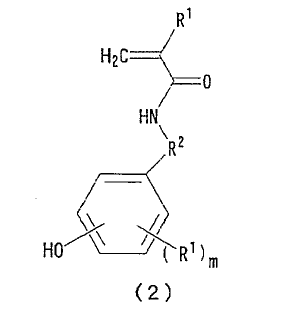 wherein R¹ individually represent a hydrogen atom or a methyl group, R² represents a single bond or a linear, branched, or cyclic divalent hydrocarbon group, and m is 1 or 2.

3. The resist pattern coating agent according to claim 1 or 2, wherein the hydroxyl group-containing resin has been obtained by polymerizing a monomer component that includes at least one of hydroxyacrylanilide and hydroxymethacrylanilide.

4. A resist pattern-forming method comprising (1) forming a first resist pattern on a substrate using a first radiation-sensitive resin composition, (2) treating the first resist pattern with the resist pattern coating agent according to any one of claims 1 to 3, and (3) forming a second resist pattern on the substrate treated with the resist pattern coating agent using a second radiation-sensitive resin composition.
